# EUROPÄISCHE PATENTSCHRIFT

(11) **EP 1 837 339 B1**
(45) Veröffentlichungstag und Bekanntmachung des Hinweises auf die Patenterteilung: **17.06.2009**
(21) Anmeldenummer: 07005116.4
(22) Anmeldetag: 13.03.2007
(51) Int. Cl.: C07F 9/30, C07F 9/32, C08K 5/5313, C08G 79/04

(54) **Phosphorhaltige Mischungen, ein Verfahren zu ihrer Herstellung und ihre Verwendung**
Phosphorous compound containing mixtures, a method of their preparation, and their use
Mélanges contenant du phosphore, procédé de fabrication et utilisation

(30) Priorität: 21.03.2006 DE 102006012879
(43) Veröffentlichungstag der Anmeldung: 26.09.2007
(73) Patentinhaber: Clariant Finance (BVI) Limited, Road Town, Tortola (VG)
(72) Erfinder: Bauer, Harald, Dr., 50170 Kerpen (DE); Dietz, Mathias, Dr., 52353 Düren (DE); Schacker, Ottmar, Dr., 86368 Gersthofen (DE)
(74) Vertreter: Jacobi, Carola

(56) Entgegenhaltungen:
- WO-A-95/24445
- US-A- 4 119 682
- US-A- 5 334 760
- US-A- 5 750 603
- PRIOLA A ET AL: "FACTORS INFLUENCING THE ADHESION PROPERTIES OF RADIATION-CURABLE COATINGS ON DIFFERENT SUBSTRATES" INTERNATIONAL CONFERENCE IN ORGANIC COATINGS SCIENCE AND TECHNOLOGY, Bd. 11, 6. Juli 1987 (1987-07-06), Seiten 156-163, XP000601060
- DATABASE WPI Week 199729 Derwent Publications Ltd., London, GB; AN 1997-316559 XP002429507 -& JP 09 124668 A (SANYO CHEM IND LTD) 13. Mai 1997 (1997-05-13)
- DATABASE WPI Week 199537 Derwent Publications Ltd., London, GB; AN 1995-280913 XP002429431 -& JP 07 179482 A (SANYO CHEM IND LTD) 18. Juli 1995 (1995-07-18)

## Beschreibung

Die Erfindung betrifft phosphorhaltige Mischungen, ein Verfahren zu ihrer Herstellung und ihre Verwendung.

Die JP-A-09/124668 beschreibt Phosphor enthaltende ethylenisch ungesättigte Monomere der Formel 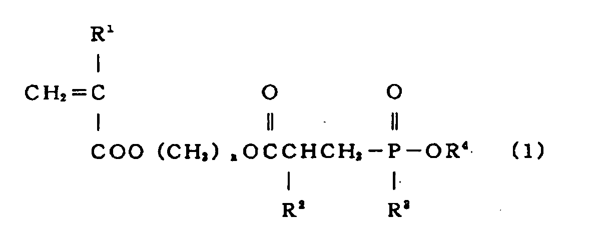 und 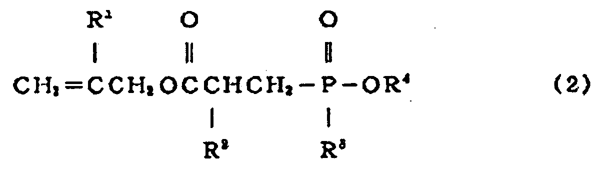 wobei R¹ und R² H-Atome und Methylgruppen und R³ eine Alkyl-, Benzyl- oder Phenyl-gruppe von 1 bis 18 Kohlenstoffatomen sein kann, R⁴ kann ein Wasserstoffatom oder eine Alkylgruppe von 1 bis 4 Kohlenstoffatomen sein und m eine ganze Zahl von 2 bis 4.

Hier werden Copolymere beschrieben, die diese Monomere enthalten, insbesondere ein Phosphor enthaltendes ethylenisch ungesättigtes Monomer mit R⁴ = H und R⁴ = Me in den mol-Verhältnissen 8 zu 2.

Das vorgenannte Monomer wird hergestellt, indem Phenyldichlorphosphan zunächst mit Acrylsäuresäure und Methanol und dann mit 2-Hydroxyethylmethacrylat umgesetzt wird. Da kein Reinigungsschritt vorgesehen ist, enthält das resultierende Produkt erhebliche Mengen halogenhaltiger Komponenten enthalten. Derartige Nebenprodukte sind bei hochwertigen Kunststoffanwendungen unerwünscht, da sie unter anderem Metallkorrosion verursachen.

Halogenhaltige Flammschutzmittel bilden im Brandfall zudem Halogenwasserstoffe. Diese sind ätzend und gesundheitsschädlich.

Die Gruppe R³ trägt nicht aktiv zum Flammschutz bei. Sie wird bevorzugt möglichst klein gehalten. Phenylgruppen sind Methylgruppen gegenüber benachteiligt. Sie verringern den Aktivgehalt an Phosphor im Flammschutzmittel.

Dieser Stand der Technik lehrt den Fachmann, dass Monomere des Typs (1) mit freier Phosphinsäuregruppe bzw. mit (nicht einreagierbarer) Methyl-veresterter Phosphinsäuregruppe für Flammschutz-Anwendungen geeignet sind.

Priola (Priola, A.; Gozzelino, G.; Ferrero, F.; Special Publication - Royal Society of Chemistry 64(1987)143-160) beschreibt ein Verfahren zur Herstellung von Verbindungen des Typs 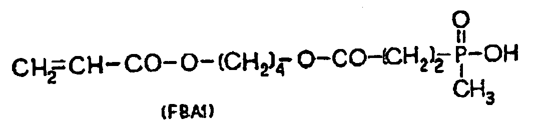 und 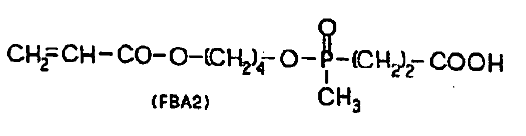 indem 2-Hydroxyethylacrylat mit Oxaphospholan bei 10 bis 20°C zu FBA1 und bei 50 bis 60°C zu FBA2 umgesetzt werden. Diese Produkte finden dann Anwendung als Adhäsionspromotoren für UV-härtbare Epoxyacryl-Beschichtungen auf Stahl finden.

Das Verfahren nach Priola sieht eine Umsetzung bei 10 bis 60°C vor. In diesem Temperaturbereich sind die meisten erfindungsgemäßen Olefinkomponenten flüssig und das Oxaphospholan fest. Das Verfahren nach Priola hat zahlreiche Nachteile: In nicht zerkleinertem Zustand ist die Reaktionsgeschwindigkeit des Oxaphospholans gering. Dies wird durch eine längere Reaktionszeit kompensiert. Nachteilig ist dabei die verfahrenstechnisch ungünstige geringe Raum-Zeit-Ausbeute, durch zu lange Wärmebehandlung kann das Monomere autopolymerisieren und unerwünschten Farbveränderungen unterliegen. Letzteres kann durch eine Zunahme der Hazen-Zahl gemessen werden.

Bisher fehlt es somit an geeigneten Phosphorenthaltenden Verbindungen, die auch längere Kohlenstoff-Ketten aufweisen, leicht herstellbar sind über Doppelbindungen (Olefin) in das Polymer einreagierbar sind und als effektive Flammschutzmittel geeignet sind.

Der Erfindung liegt daher die Aufgabe zugrunde, ein reaktives halogenfreies Flammschutzmittel zur Verfügung zu stellen, das die oben genannten Nachteile vermeidet, leicht herstellbar ist und nur sehr niedrige Halogen-Gehalte aufweist.

Gelöst wird diese Aufgabe durch Mischungen, enthaltend Verbindungen der Formel

(I) RO-P(=O)(A)-CH₂-CH₂-CO₂H und

(II) HO-P(=O)(A)-CH₂-CH₂-CO₂R

worin
- A: Methyl, Ethyl, Propyl oder Butyl,
- R: (D,E)C=C(B, R⁵)
- B, D, E: gleich oder verschieden sind und jeweils H oder methyl
- R⁵: R⁵ ein gesättigtes, ungesättigtes oder mehrfach ungesättigtes C₁-C₂₀-(-CO-O-Hydroxyalkylen).
bedeuten.

Insbesondere bedeutet R⁵ -CO-O-CH₂-CH(OH)-CH₂-, -CO-O-CH₂-C(CH₂OH)₂-CH₂-, -CO-O-(CH₂)₂-CH(OH)-CH₂- oder -CO-O-CH₂-C(CH₃)(CH₂OH)₂-CH₂- .

Bevorzugt enthalten die erfindungsgemäßen Mischungen Verbindungen der Formel

(I) RO-P(=O)(A) - CH₂-CH₂-CO₂H und

(II) H-OP(=O)(A) - CH₂-CH₂-CO₂-R, worin

- A: Methyl, Ethyl, Propyl oder Butyl,
- R: (D,E)C=C(B, R⁵), wobei
- D: H oder Methyl,
- E: H oder Methyl,
- B: H oder Methyl,
- R⁵: -CO-O-CH₂-CH(OH)-CH₂-, -CO-O-CH₂-C(CH_{2O}H)₂-CH₂-, -CO-O-(CH₂)₂-CH(OH)-CH₂- oder -CO-O-CH₂-C(CH₃)(CH₂OH)₂-CH₂- bedeuten.

Die Mischungen enthalten 99,9 bis 20 Gew.-% an Verbindungen der Formel (I) und 0,1 bis 80 Gew.-% an Verbindungen der Formel (II), wobei die Summe der Komponenten immer 100 Gew.-% beträgt.

Die Erfindung betrifft auch ein Verfahren zur Herstellung von erfindungsgemäßen Mischungen, enthaltend Verbindungen der Formel

(I) RO-PO(A)-CH₂-CH₂-CO₂H und

(II) HO-PO(A)-CH₂-CH₂-CO₂R worin

- A: Methyl, Ethyl, Propyl oder Butyl,
- R: (D,E)C=C(B, R⁵),
- B, D, E: gleich oder verschieden sind und jeweils H oder methyl
- R⁵: ein gesägttigtes, ungesättigtes oder mehrfach ungesägttigtes C₁-C₂₀-C-CO-O-Hydroxyalkylen
bedeuten, dadurch gekennzeichnet, dass ein Oxaphospholan mit einer Di-, Tri- oder Polyhydroxylhaltigen Olefinkomponente umgesetzt wird, wobei das Oxaphospholan der Formel (III) 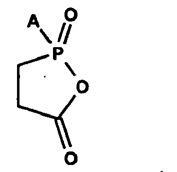 entspricht. Insbesondere bedeutet R⁵ -CO-O-CH₂-CH(OH)-CH₂-, -CO-O-CH₂-C(CH₂OH)₂-CH₂-, -CO-O-(CH₂)₂-CH(OH)-CH₂- oder -CO-O-CH₂-C(CH₃)(CH₂OH)₂-CH₂.

Beim erfindungsgemäßen Verfahren enthalten die Mischungen 99,9 bis 20 Gew.-% an Verbindungen der Formel (1) und 0,1 bis 80 Gew.-% an Verbindungen der Formel (II), wobei die Summe der Komponenten immer 100 Gew.-% beträgt.

Die Erfindung betrifft auch die Verwendungen von Mischungen nach mindestens einem der Ansprüche 1 bis 5 als Flammschutzmittel oder zur Herstellung von Flammschutzmittel-Zusammensetzungen.

Die Erfindung betrifft somit auch Flammschutzmittel-Zusammensetzungen, dadurch gekennzeichnet, dass sie 99,5 bis 40 Gew.-% Mischungen nach mindestens einem der Ansprüche 1 bis 5 und 0,1 bis 60 Gew.-% Olefinkomponente enthalten, wobei die Summe der Komponenten immer 100 Gew.-% beträgt.

Bevorzugt enthalten die Flammschutzmittel-Zusammensetzungen 90 bis 50 Gew.-% Mischungen nach mindestens einem der Ansprüche 1 bis 5 und 10 bis 50 Gew.-% Olefinkomponente, wobei die Summe der Komponenten immer 100 Gew.-% beträgt.

Die Erfindung betrifft auch eine flammgeschützte Polymerformmasse, dadurch gekennzeichnet, dass sie
0,5 bis 50 Gew.-% Mischungen nach mindestens einem der Ansprüche 1 bis 5
1 bis 99 Gew.-% thermoplastisches Polymer oder Mischungen derselben,
0 bis 60 Gew.-% Additive und 0 bis 60 Gew.-% Füllstoff enthält, wobei die Summe der Komponenten immer 100 Gew.-% beträgt.

Bevorzugt handelt es sich bei den thermoplastischen Polymeren um Polystyrol-HI (High-Impact), Polyphenylenether, Polyamide, Polyester, Polycarbonate und Blends oder Polymerblends vom Typ ABS (Acrylnitril-Butadien-Styrol) oder PC/ABS (Polycarbonat/ Acrylnitril-Butadien-Styrol).

Die Erfindung betrifft auch Polymer-Formkörper, -Filme, -Fäden und -Fasern enthaltend 0,5 bis 50 Gew.-% Mischungen nach mindestens einem der Ansprüche 1 bis 5 oder eine flammgeschützte Polymerformmasse nach Anspruch 28 oder 29.

Bevorzugt handelt es sich bei dem Polymer der Polymer-Formkörper, -Filme, -Fäden und -Fasern um ein thermoplastisches oder duroplastisches Polymer.

Bevorzugt handelt es sich bei dem thermoplastischen Polymeren um Polystyrol-HI (High-Impact), Polyphenylenether, Polyamide, Polyester, Polycarbonate und Blends oder Polymerblends vom Typ ABS (Acrylnitril-Butadien-Styrol) oder PC/ABS (Polycarbonat/ Acrylnitril-Butadien-Styrol), Polyamid, Polyester und/oder ABS.

Bevorzugt handelt es sich bei den duroplastischen Polymeren um Formaldehyd-, Epoxid-, Melamin- Phenolharz-Polymere und/oder Polyurethane.

Bevorzugt enthalten die Polymer-Formkörper, -Filme, -Fäden und -Fasern
0,5 bis 50 Gew.-% Mischungen nach mindestens einem der Ansprüche 1 bis 5,
1 bis 99 Gew.-% Polymer oder Mischungen derselben,
0 bis 60 Gew.-% Additive und 0 bis 60 Gew.-% Füllstoff, wobei die Summe der Komponenten immer 100 Gew.-% beträgt.

Bevorzugt enthalten die Polymer-Formkörper, -Filme, -Fäden und -Fasern
1 bis 40 Gew.-% Mischungen nach mindestens einem der Ansprüche 1 bis 5,
1 bis 99 Gew.-% duroplastisches Polymer oder Mischungen derselben,
0,5 bis 60 Gew.-% Additive und 0,5 bis 60 Gew.-% Füllstoff und/oder Verstärkungsstoff, wobei die Summe der Komponenten immer 100 Gew.-% beträgt.

Bevorzugt handelt es sich bei dem duroplastischen Polymer in den Polymer-Formkörpern, -Filmen, -Fäden und -Fasern um ungesättigte Polyesterharze, Dicyclopentadien-modifizierte ungesättigte Polyester, Polyphenylenether oder Butadien-Polymere.

Bevorzugt finden die Polymer-Formkörper, -Filme, -Fäden und -Fasern in elektrischen Schalterteilen, Bauteilen in Automobilbau, Elektrotechnik, Elektronik, Leiterplatten, Prepregs, Vergussmassen für elektronische Bauteile, im Boots- und Rotorblattbau, in GFK-Außenanwendungen, Haushalts- und Sanitäranwendungen, Engineering-Werkstoffen und weiteren Produkten Anwendung.

Bevorzugt bedeutet A C₁-C₆-Alkyl.

Besonders bevorzugt bedeutet A Methyl, Ethyl oder Propyl.

Bevorzugt sind B, D und E gleich oder verschieden bedeuten jeweils H oder Methyl.

Besonders bevorzugt bedeutet R⁵ ein gesättigtes C₁-C₆-(-CO-O-Hydroxyalkylen).

Besonders bevorzugt enthalten die Mischungen 99 bis 30 Gew.-% an Verbindungen der Formel (1) und 1 bis 70 Gew.-% an Verbindungen der Formel (11), wobei die Summe der Komponenten immer 100 Gew.-% beträgt.

Bevorzugt sind die erfindungsgemäßen Mischungen Methylesterfrei.

Bevorzugt weisen die erfindungsgemäßen Mischungen einen Chloridgehalt von maximal 0,005 Gew.-% auf.

Bevorzugt enthalten die erfindungsgemäßen Mischungen Verbindungen, in denen A Methyl, R⁵ -CO-O-CH₂-CH(OH)-CH₂- und D, E und B jeweils H bedeuten: 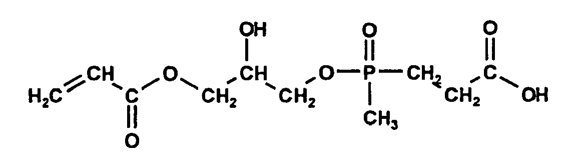 und

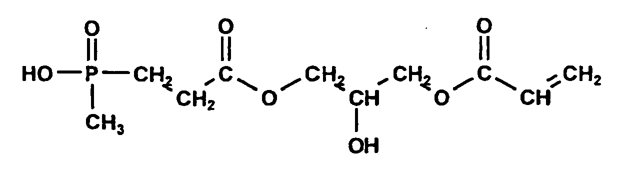

Bevorzugt enthalten die erfindungsgemäßen Mischungen Verbindungen, in denen A Ethyl, R⁵ -CO-O-CH₂-CH(OH)-CH₂- und D, E und B jeweils H bedeuten: 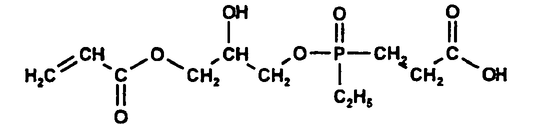 und

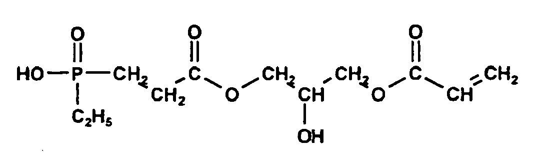

Bevorzugt enthalten die erfindungsgemäßen Mischungen Verbindungen, in denen A Phenyl, R⁵ -CO-O-CH₂-CH(OH)-CH₂- und D, E und B jeweils H bedeuten: 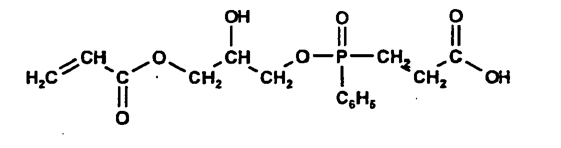 und

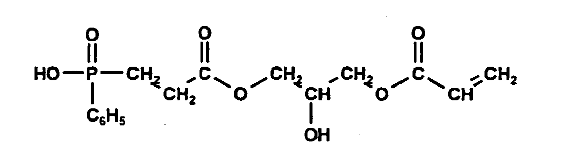

Bevorzugt enthalten die erfindungsgemäßen Mischungen Verbindungen, in denen A Methyl, B Methyl, R⁵ -CO-O-CH₂-CH(OH)-CH₂- und D und E jeweils H bedeuten: 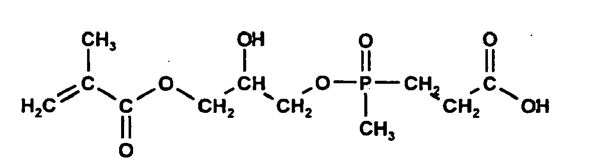 und

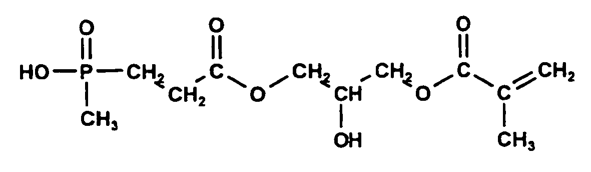

Bevorzugt enthalten die erfindungsgemäßen Mischungen Verbindungen, in denen A Ethyl, B Methyl, R⁵ -CO-O-CH₂-CH(OH)-CH₂-CH₂ und D und E jeweils H bedeuten: 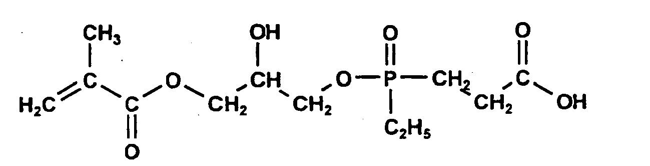 und

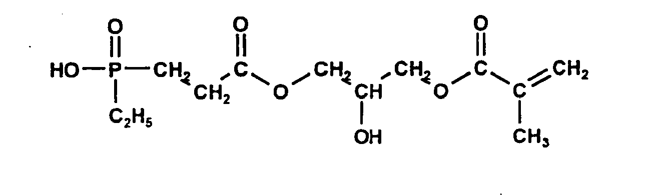

Bevorzugt enthalten die erfindungsgemäßen Mischungen Verbindungen, in denen A Phenyl, B Methyl, R⁵ -CO-O-CH₂-CH(OH)-CH₂- und D und E jeweils H bedeuten: 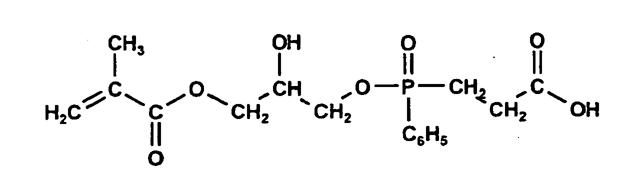 und

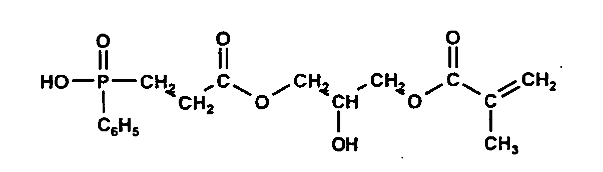

Bevorzugt enthalten die erfindungsgemäßen Mischungen Verbindungen, in denen A und B jeweils Methyl, R⁵ -CO-O-CH₂-C(CH₂OH)₂-CH₂ und D und E jeweils H bedeuten: 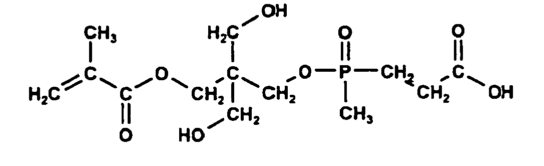 und

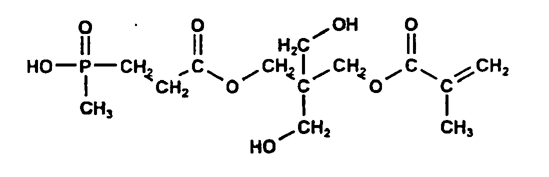

Bevorzugt enthalten die erfindungsgemäßen Mischungen Verbindungen, in denen A Ethyl, B Methyl, R⁵ -CO-O-CH₂-C(CH₂OH)₂-CH₂- und D und E jeweils H bedeuten: 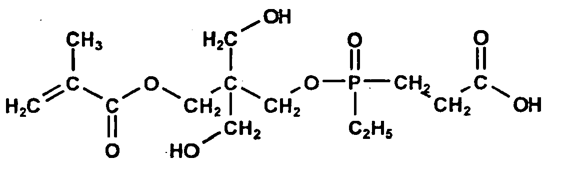 und

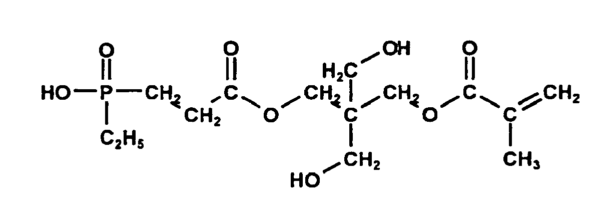

Bevorzugt enthalten die erfindungsgemäßen Mischungen Verbindungen, in denen A Phenyl, B Methyl, R⁵ -CO-O-CH₂-C(CH₂C)H)₂-CH₂ und D und E jeweils H edeuten: 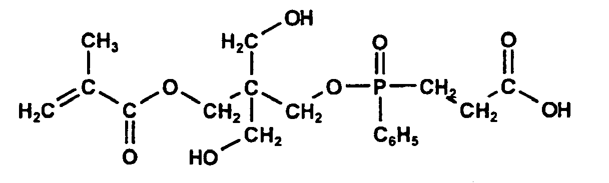 und

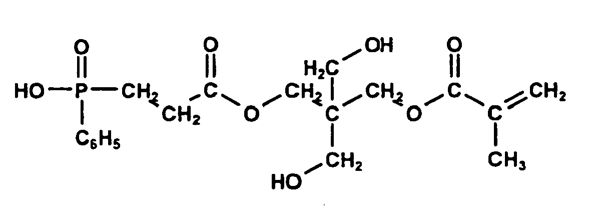

Bevorzugt enthalten die erfindungsgemäßen Mischungen Verbindungen, in denen A und B jeweils Methyl, R⁵ -CO-O-CH₂-C(CH₃)(CH₂OH)₂-CH₂- und D und E jeweils H bedeuten: 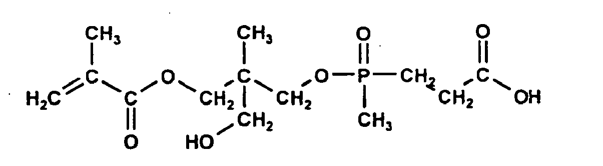 und

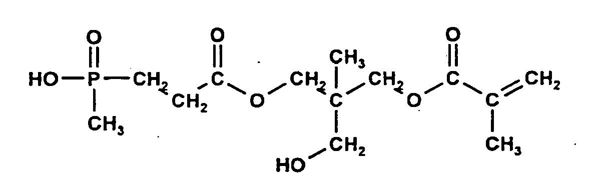

Bevorzugt enthalten die erfindungsgemäßen Mischungen Verbindungen, in denen A Ethyl, B Methyl, R⁵ -CO-O-CH₂-C(CH₃)(CH₂OH)₂-CH₂ und D und E jeweils H bedeuten: 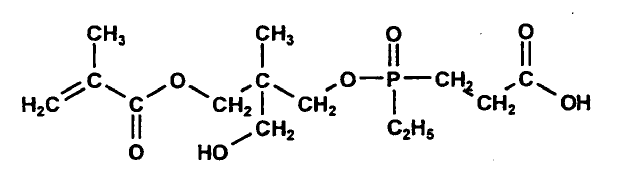 und

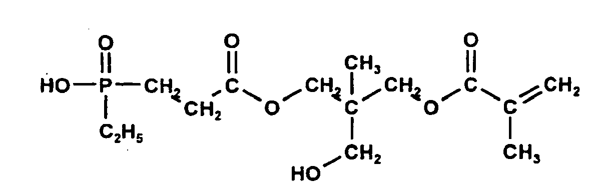

Bevorzugt enthalten die erfindungsgemäßen Mischungen Verbindungen, in denen A Phenyl, B Methyl, R⁵ -CO-O-CH₂-C(CH₃)(CH₂OH)₂-CH₂-CH₂ und D und E jeweils H bedeuten: 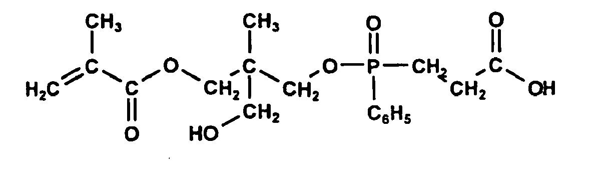 und

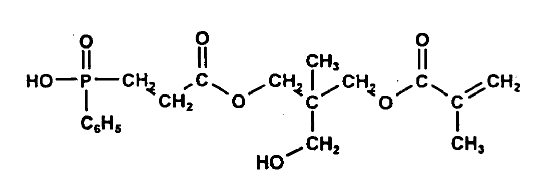

Bevorzugt enthalten die erfindungsgemäßen Mischungen Verbindungen, in denen A und B jeweils Methyl, R⁵ -CO-O-(CH₂)₂-CH(OH)-CH₂- und D und E jeweils H bedeuten: 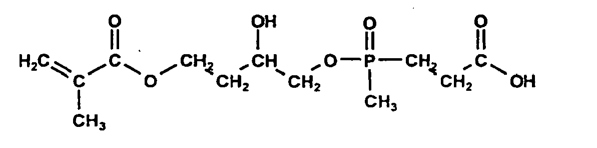 und

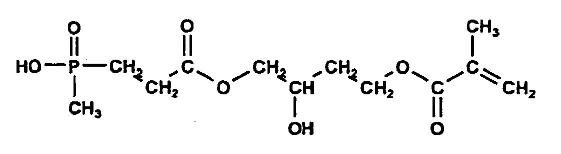

Bevorzugt enthalten die erfindungsgemäßen Mischungen Verbindungen, in denen A Ethyl, B Methyl, R⁵ -CO-O-(CH₂)₂-CH(OH)-CH₂- und D und E jeweils H bedeuten: 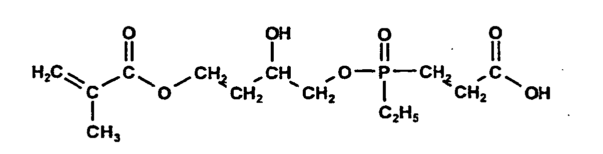 und

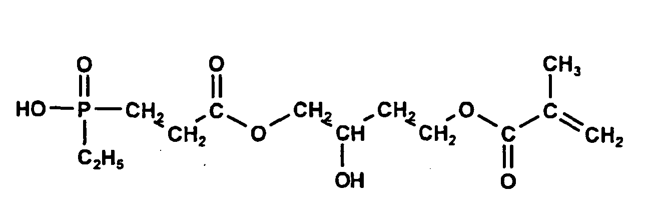

Bevorzugt enthalten die erfindungsgemäßen Mischungen Verbindungen, in denen A Phenyl, B Methyl, R⁵ -CO-O-(CH₂)₂-CH(OH)-CH₂- und D und E jeweils H bedeuten: 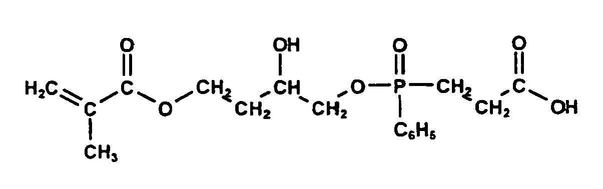 und

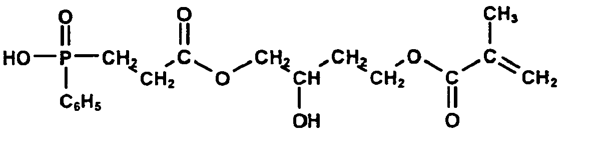

Wie oben bereits beansprucht, können A, R⁵, D, E und B in weiten Grenzen variiert werden. Gegenstand der vorliegenden Erfindung sind daher nicht nur die vorstehend beschriebenen Mischungen, sondern auch alle die nicht durch die Darstellung einzelner Molekülschemata abgebildet werden, bis hin zu längerkettigen Teilen in der jeweiligen Verbindung.

Grundsätzlich können die erfindungsgemäßen Mischungen auch Anteile an Verbindungen der Formel RO-PO(A)-CH₂-CH₂-CO₂R enthalten, wobei A und R die eingangs genannte Bedeutung aufweisen.

Bevorzugt können die erfindungsgemäßen Mischungen auch 0,1 bis 80 Gew.-% an Verbindungen der Formel RO-PO(A)-CH₂-CH₂-CO₂R enthalten, wobei A und R die eingangs genannte Bedeutung aufweisen.

Die erfindungsgemäßen Mischungen weisen trotz teilweise nur recht geringer Phosphor-Gehalte eine gute Flammschutzwirkung auf. Sie werden durch eine Umsetzung von Oxaphospholan und einer Olefinkomponente hergestellt. Dazu kann die Olefinkomponente vorgelegt und Oxaphospholan zugegeben werden oder, in umgekehrter Reihenfolge, Oxaphospholan vorgelegt und dann die Olefinkomponente zugegeben werden.

Bevorzugt bedeutet A C₁-C₆-Alkyl.

Besonders bevorzugt bedeutet A Methyl, Ethyl oder Propyl.

Bevorzugt entspricht die Olefinkomponente der Formel (IV)

(D,E)C=C(B)- R⁵-OH

worin B, D, E gleich oder verschieden sind und jeweils H oder C₁-C₁₈-Alkyl und R⁵ C₁-C₂₀-(-CO-O-Hydroxyalkylen) bedeuten.

Bevorzugt sind B, D und E gleich oder verschieden und bedeuten jeweils H oder Methyl.

Bevorzugt bedeutet R⁵ ein gesättigtes, ungesättigtes oder mehrfach ungesättigtes C₁-C₂₀-(-CO-O-Hydroxyalkylen).

Besonders bevorzugt bedeutet R⁵ ein gesättigtes C₁-C₆-(-CO-O-Hydroxyalkylen).

Besonders bevorzugt enthalten beim erfindungsgemäßen Verfahren die Mischungen 99 bis 30 Gew.-% an Verbindungen der Formel (I) und 1 bis 70 Gew.-% an Verbindungen der Formel (II), wobei die Summe der Komponenten immer 100 Gew.-% beträgt.

Bevorzugt wird das Oxaphospholan in Form eines Pulvers oder einer Schmelze umgesetzt.

Bevorzugt handelt es sich bei dem Oxaphospholan um 2-Methyl-2,5-dioxo-1-oxa-2-phospholan, 2-Ethyl-2,5-dioxo-1-oxa-2-phospholan, 2-n-Butyl-2,5-dioxo-1-oxa-2-phospholan, 2-Hexyl-2,5-dioxo-1-oxa-2-phospholan, 2-Octyl-2,5-dioxo-1-oxa-2-phospholan oder 2-Phenyl-2,5-dioxo-1-oxa-2-phospholan.

Bevorzugt handelt es sich bei der Olefinkomponente um Acrylsäure-2,3-bishydroxypropylester, Methacrylsäure-2,3-bishydroxypropylester, Acrylsäure-2,2'-bishydroxymethyl-3-hydroxy-propylester, Acrylsäure-3,4-bishydroxybutylester oder Acrylsäure-2-methyl-2-hydroxymethyl-propylester

Bevorzugt wird Oxaphospholan als Pulver zugegeben, bevorzugt ist die mittlere Teilchengröße des Oxaphospholans 0,1 bis 1000 µm, insbesondere 10 bis 300 µm. Das Oxaphospholan kann aber auch als Schmelze zugegeben werden. Bevorzugt wird dann das Oxaphospholan als Schmelze mit einer Temperatur von 100 bis 200°C, besonders bevorzugt 110 bis 130°C, zugegeben.

Bevorzugt wird die Olefinkomponente bei 10 bis 100°C vorgelegt und die resultierende Reaktionslösung auf ebenfalls 10 bis 100°C temperiert.

Bevorzugt erfolgt die Umsetzung in Rührkesseln oder statischen Mischern.

Bevorzugt werden als Mischorgane Anker-, Blatt-, MIG-, Propeller-, lmpeller-, Turbinen-, Kreuz-Rührer, Dispergierscheiben, Rotor-Stator-Mischer, statische Mischer, Venturi-Düsen und/oder Mammutpumpen eingesetzt.

Bevorzugt erfährt die Reaktionslösung eine Mischintensität, die einer Rotations-Reynolds-Zahl von 1 bis 1000000, bevorzugt von 100 bis 100000 entspricht.

Bevorzugt erfährt die Reaktionslösung einen Energieeintrag von 0,083 bis 10 kW/m³, bevorzugt 0,33 - 1,65 kW/m³.

Bevorzugte Olefinkomponenten sind ungesättigte Alkohole z.B. Allylalkohol, 3-Buten-1-ol, 3-Hydroxy-1-buten, 3-Buten-2-ol, Methyl-vinylcarbinol, 2-Methyl-2-Propen-1-ol , Methallylalkohol, 2-Buten-1-ol, Crotylalkohol, 1-Penten-3-ol, trans -2-Penten-1-ol, cis -2-Penten-1-ol, 3-Penten-2-ol, 4-Penten-1-ol, 4-Penten-2-ol, , 1-Hexen-3-ol, cis-2-Hexen-1-ol, trans-2-Hexen-1-ol, cis-3-Hexen-1-ol, trans-3-Hexen-1-ol, 4-Hexen-1-ol, 5-Hexen-1-ol, 5-Hexen-2-ol, 1-Hepten-3-ol, 1-Octen-3-ol, trans-2-Octen-1-ol, Oleylalkohol oder Terpenalkohol.

Die vorgenannten Verbindungen (I) RO-P(=O)(A) - CH₂-CH₂-CO₂H und (II) H-OP(=O)(A) - CH₂-CH₂-CO₂-R sind grundsätzlich als reaktive Flammschutzmittel direkt einsetzbar. Häufig bedingen die Anwendungen jedoch physikalische Eigenschaften, die die Verbindungen nicht aufweisen. Eine wichtige Kenngröße ist die Viskosität. Diese bestimmt die Einfachheit des Einarbeitens in die Polymere.

Die erfindungsgemäßen Mischungen zeigen die gewünschte und benötigte Viskosität, die einzelnen Verbindungen (I) und (II) jedoch häufig nicht, so dass bei den letzteren Hilfsmitteln zur Einarbeitung in die Polymere zugesetzt werden müssen.

In den erfindungsgemäßen Flammschutzmittel-Zusammensetzungen werden als Hilfsmittel Überschüsse der Olefinkomponente eingesetzt.

Die bevorzugte Viskosität der erfindungsgemäßen Mischungen ist 50 bis 1000 cP.

Die erfindungsgemäßen Mischungen finden bevorzugt Verwendung als Flammschutzmittel. Die Anbindung der erfindungsgemäßen Mischungen an das Polymer erfolgt bevorzugt durch die Umsetzung der olefinischen Gruppe in den jeweiligen Verbindungen.

Erfindungsgemäß können auch die Phosphinsäuregruppe bzw. Carboxylsäuregruppe der jeweiligen Verbindungen mit geeigneten funktionellen Gruppen der Polymermatrix bzw. Comonomere kondensieren. Bevorzugte funktionelle Gruppen sind Hydroxylgruppen.

Bevorzugt enthält die flammgeschützte Polymerformmasse
1 bis 40 Gew.-% Mischungen nach mindestens einem der Ansprüche 1 bis 5,
5 bis 90 Gew.-% thermoplastisches Polymer oder Mischungen derselben,
5 bis 40 Gew.-% Additive und 5 bis 40 Gew.-% Füllstoff, wobei die Summe der Komponenten immer 100 Gew.-% beträgt.

Bevorzugt handelt es sich bei den thermoplastischen Polymeren um Polyamid, Polyester oder ABS.

Ein Verfahren zur Herstellung von erfindungsgemäß flammgeschützten Formmassen besteht darin dass die erfindungsgemäßen Mischungen
a) gemeinsam mit anderen/weiteren Comonomeren zu flammgeschützten Polymeren umgesetzt werden, oder
b) für sich zu einem Homopolymerisat polymerisiert und dann mit Polymeren nach dem Stand der Technik durch Extrudieren, Compoundieren etc. geblendet wird, oder
c) mit anderen/weiteren Comonomeren zu einem Copolymerisat umgesetzt und dann mit Polymeren nach dem Stand der Technik durch Extrudieren, Compoundieren etc. geblendet wird.

Ein Verfahren zur Herstellung von flammgeschützten Polymerformmassen ist dadurch gekennzeichnet, dass ein erfindungsgemäße Mischungen enthaltendes Polymerisat mit dem Polymergranulat und evtl. Additiven vermischt und auf einem Doppelschnecken-Extruder (ZSK 25 WLE, 14,5 kg/h, 200 U/min, UD: 4) bei Temperaturen von 170 °C (Polystyrol), ca. 270°C (PET, Polyethylenterephthalat), 230 bis 260°C (Polybutylenterephthalat, PBT), von 260°C (PA6) bzw. von 260 bis 280°C (PA 66) eingearbeitet wird. Der homogenisierte Polymerstrang wird abgezogen, im Wasserbad gekühlt, anschließend granuliert und auf einen Restfeuchtegehalt von 0,05 bis 5 %, bevorzugt 0,1 bis 1 Gew.-%, getrocknet.

Die Erfindung betrifft auch Polymer-Formkörper, -Filme, -Fäden und -Fasern enthaltend 0,5 bis 50 Gew.-% Mischungen nach mindestens einem der Ansprüche 1 bis 5 oder eine flammgeschützte Polymerformmasse, die dann die erfindungsgemäßen Mischungen enthält.

Besonders bevorzugt enthalten die Polymer- Formkörper, -Filme, -Fäden und -Fasern
1 bis 40 Gew.-% Mischungen nach mindestens einem der Ansprüche 1 bis 5,
1 bis 99 Gew.-% Polymer oder Mischungen derselben,
0 bis 60 Gew.-% Additive und 0 bis 60 Gew.-% Füllstoff, wobei die Summe der Komponenten immer 100 Gew.-% beträgt.

Erfindungsgemäß bevorzugte Comonomeren sind Methylacrylat, 1,2-Butadien, 1,3 Butadien, 2-Ethylhexylacrylat, Acrylamid, Acrylnitril, Acrylsäure, Ethylacrylat, Ethylmethacrylat, Laurylacrylat und/oder Methylmethacrylat, Methacrylamid, Methacrylnitril, Methacrylsäure, n-Butylacrylat, i-Butylacrylat, sec-Butylacrylat, n-Butylmethacrylat, i-Butylmethacrylat n-Hexylacrylat, n-Hexylmethacrylat, n-Propylacrylat, tert-Butylacrylat, tert-Butylmethacrylat, Vinylacetat, Vinylchlorid, Vinylidenchlorid, Vinylpropionat, Octyl(meth)acrylate, Isooctyl (meth)acrylate, Decyl(meth)acrylate, Dodecyl(meth)acrylate, Itaconsäure, Maleinsäure, Cyanoalkyl(meth)acrylate, substituierte Acrylamide wie N,N'-Dimethylacrylamid, N-Vinylpyrrolidon, N-Vinylcaprolactam, N-Vinylpiperidin und Acrylnitril, Tricyclodecyl(meth)acrylat, lsobornyl(meth)acrylate, Hydroxy(meth)acrylate, Styrol, p-Methylstyrol, Vinyltoluol, alpha-Methylstyrol.

Erfindungsgemäße flammgeschützte thermoplastische Formmassen und/oder Formkörper können auf Polymethylmethacrylat basieren.

Bevorzugte Polymethylmethacylate sind Homo- oder Copolymersiate eines oder mehrerer folgender Monomeren: (Meth)acrylsäure-Monomer mit einer Alkylgruppe von 1 bis 20 C-Atomen, z.B. Ethyl(meth)acrylat, Butyl(meth)acrylat, n-Propyl(meth)acrylat, i-Propyl(meth)acrylat, n-Butyl(meth)acrylat, i-Butyl(meth)acrylat, sec-Butyl(meth)acrylat, tert-Butyl(meth)acrylat, n-Hexyl(meth)acrylat, cyclo-Hexyl(meth)acrylat, n-Octyl(meth)acrylat, 2-Ethylhexyl(meth)acrylat, Isooctyl(meth)acrylat, n-Decyl(meth)acrylat, Dodecyl(meth)acrylat, Tricyclodecyl(meth)acrylat, Hexadecyl(meth)acrylat, Octadecyl(meth)acrylat, Bornyl(meth)acrylat, Isobornyl(meth)acrylat, Menthyl(meth)acrylat, Phenyl(meth)acrylat, 1-Naphtyl(meth)-acrylat, Benzyl(meth)acrylat, 2-Hydroxyethyl(meth)acrylat, Cyanoalkyl(meth)acrylat, Acrylamid, substituierte Acrylamide, z.B. N,N'-Dimethylacrylamid und N-Vinylpyrrolidon, N-Vinylcaprolactam, N-Vinylpiperidin und Acrylonitril.

Bevorzugte Verwendungen für erfindungsgemäße flammgeschützte thermoplastische Formmassen und/oder Formkörper, die auf Polymethylmethacrylat basieren, sind Auto-, Schiffsbeleuchtung, Blinkleuchten, Verkehrsampeln, Lichtkuppeln, Bauverglasungen, Lichtreklamen, KFZ-, Lichtleiter, Scheinwerferoptik, Sanitär-Armaturen, Elektronikanwendungen, Bildschirm-, Display-Vorsatzscheiben, Teile in der Feinwerktechnik, Apparatebau, Mess-, Zeichen-, Schreibgeräte, Linsen-, Brillengläser, optische Speichermedien und Datenträger, medizinische Anwendungen, Nahrungsmittel- und Medikamentenverpackungen.

Bevorzugt handelt es sich bei den thermoplastischen Polymeren um Polymere von Mono- und Diolefinen, beispielsweise Polypropylen, Polyisobutylen, Polybuten-1, Poly-4-methyl-penten-1, Polyisopren oder Polybutadien sowie Polymerisate von Cycloolefinen wie z.B. von Cyclopenten oder Norbornen; ferner Polyethylen (das gegebenenfalls vernetzt sein kann), z.B. Polyethylen hoher Dichte (HDPE), Polyethylen hoher Dichte und hoher Molmasse (HDPE-HMW), Polyethylen hoher Dichte und ultrahoher Molmasse (HDPE-UHMW), Polyethylen mittlerer Dichte (MDPE), Polyethylen niederer Dichte (LDPE), lineares Polyethylen niederer Dichte (LLDPE), verzweigtes Polyethylen niederer Dichte (VLDPE), sowie Mischungen davon.

Bevorzugt handelt es sich bei den thermoplastischen Polymeren um Copolymere von Mono- und Diolefinen untereinander oder mit anderen Vinylmonomeren, wie z.B. Ethylen-Propylen-Copolymere, lineares Polyethylen niederer Dichte (LLDPE) und Mischungen desselben mit Polyethylen niederer Dichte (LDPE), Propylen-Buten-1-Copolymere, Propylen-Isobutylen-Copolymere, Ethylen-Buten-1-Copofymere, Ethylen-Hexen-Copolymere, Ethylen-Methylpenten-Copolymere, Ethylen-Hepten-Copolymere, Ethylen-Octen-Copolymere, Propylen-Butadien-Copolymere, lsobutylen-Isopren-Copolymere, Ethylen-Alkylacrylat-Copolymere, Ethylen-Alkylmethacrylat-Copolymere, Ethylen-Vinylacetat-Copolymere und deren Copolymere mit Kohlenstoffmonoxid, oder Ethylen-Acrylsäure-Copolymere und deren Salze (lonomere), sowie Terpolymere von Ethylen mit Propylen und einem Dien, wie Hexadien, Dicyclopentadien oder Ethylidennorbornen; ferner Mischungen solcher Copolymere untereinander, z.B. Polypropylen/Ethylen-Propylen-Copolymere, LDPE/Ethylen-Vinylacetat-Copolymere, LDPE/Ethylen-Acrylsäure-Copolymere, LLDPE/Ethylen-Vinylacetat-Copolymere, LLDPE/Ethylen-Acrylsäure-Copolymere und alternierend oder statistisch aufgebaute Polyalkylen/ Kohlenstoffmonoxid-Copolymere und deren Mischungen mit anderen Polymeren wie z.B. Polyamiden.

Bevorzugt handelt es sich bei den thermoplastischen Polymeren um Kohlenwasserstoffharze (z.B. C₅-C₉) inklusive hydrierte Modifikationen davon (z.B. Klebrigmacherharze) und Mischungen von Polyalkylenen und Stärke.

Bevorzugt handelt es sich bei den thermoplastischen Polymeren um Polystyrol (Polystyrol 143E (BASF), Poly-(p-methylstyrol), Poly-(alpha-methylstyrol).

Bevorzugt handelt es sich bei den thermoplastischen Polymeren um Copolymere von Styrol oder alpha-Methylstyrol mit Dienen oder Acrylderivaten, wie z.B. Styrol-Butadien, Styrol-Acrylnitril, Styrol-Alkylmethacrylat, Styrol-Butadien-Alkylacrylat und -methacrylat, Styrol-Maleinsäureanhydrid, Styrol-Acrylnitril-Methylacrylat; Mischungen von hoher Schlagzähigkeit aus Styrol-Copolymeren und einem anderen Polymer, wie z.B. einem Polyacrylat, einem Dien-Polymeren oder einem Ethylen-Propylen-Dien-Terpolymeren; sowie Block-Copolymere des Styrols, wie z.B. Styrol-Butadien-Styrol, Styrol-Isopren-Styrol, Styrol-Ethylen/Butylen-Styrol oder Styrol-Ethylen/Propylen-Styrol.

Bevorzugt handelt es sich bei den thermoplastischen Polymeren um Pfropfcopolymere von Styrol oder alpha-Methylstyrol, wie z.B. Styrol auf Polybutadien, Styrol auf Polybutadien-Styrol- oder Polybutadien-Acrylnitril-Copolymere, Styrol und Acrylnitril (bzw. Methacrylnitril) auf Polybutadien; Styrol, Acrylnitril und Methylmethacrylat auf Polybutadien; Styrol und Maleinsäureanhydrid auf Polybutadien; Styrol, Acrylnitril und Maleinsäureanhydrid oder Maleinsäureimid auf Polybutadien; Styrol und Maleinsäureimid auf Polybutadien, Styrol und Alkylacrylate bzw. Alkylmethacrylate auf Polybutadien, Styrol und Acrylnitril auf Ethylen-Propylen-Dien-Terpolymeren, Styrol und Acrylnitril auf Polyalkylacrylaten oder Polyalkylmethacrylaten, Styrol und Acrylnitril auf Acrylat-Butadien-Copolymeren, sowie deren Mischungen, wie sie z.B. als sogenannte ABS-, MBS-, ASA- oder AES-Polymere bekannt sind.

Bevorzugt handelt es sich bei den thermoplastischen Polymeren um halogenhaltige Polymere, wie z.B. Polychloropren, Chlorkautschuk, chloriertes und bromiertes Copolymer aus Isobutylen-Isopren (Halobutylkautschuk), chloriertes oder chlorsulfoniertes Polyethylen, Copolymere von Ethylen und chloriertem Ethylen, Epichlorhydrinhomo- und -copolymere, insbesondere Polymere aus halogenhaltigen Vinylverbindungen, wie z.B. Polyvinylchlorid, Polyvinylidenchlorid, Polyvinylfluorid, Polyvinylidenfluorid; sowie deren Copolymere, wie Vinylchlorid-Vinylidenchlorid, Vinylchlorid-Vinylacetat oder Vinylidenchlorid-Vinylacetat.

Bevorzugt handelt es sich bei den thermoplastischen Polymeren um Polymere, die sich von alpha-, beta-ungesättigten Säuren und deren Derivaten ableiten, wie Polyacrylate und Polymethacrylate, mit Butylacrylat schlagzäh modifizierte Polymethylmethacrylate, Polyacrylamide und Polyacrylnitrile und Copolymere der genannten Monomeren untereinander oder mit anderen ungesättigten Monomeren, wie z.B. Acrylnitril-Butadien-Copolymere, Acrylnitril-Alkylacrylat-Copolymere, Acrylnitril-Alkoxyalkylacrylat-Copolymere, Acrylnitril-Vinylhalogenid-Copolymere oder Acrylnitril-Alkylmethacrylat-Butadien-Terpolymere.

Bevorzugt handelt es sich bei den thermoplastischen Polymeren um Polymere, die sich von ungesättigten Alkoholen und Aminen bzw. deren Acylderivaten oder Acetalen ableiten, wie Polyvinylalkohol, Polyvinylacetat, -stearat, -benzoat, -maleat, Polyvinylbutyral, Polyallylphthalat, Polyallylmelamin; sowie deren Copolymere mit Olefinen.

Bevorzugt handelt es sich bei den thermoplastischen Polymeren um Homo- und Copolymere von cyclischen Ethern, wie Polyalkylenglykole, Polyethylenoxyd, Polypropylenoxyd oder deren Copolymere mit Bisglycidylethern.

Bevorzugt handelt es sich bei den thermoplastischen Polymeren um Polyacetale, wie Polyoxymethylen, sowie solche Polyoxymethylene, die Comonomere, wie z.B. Ethylenoxid, enthalten; Polyacetale, die mit thermoplastischen Polyurethanen, Acrylaten oder MBS modifiziert sind.

Bevorzugt handelt es sich bei den thermoplastischen Polymeren um Polyphenylenoxide und -sulfide und deren Mischungen mit Styrolpolymeren oder Polyamiden.

Bevorzugt handelt es sich bei den thermoplastischen Polymeren um Polyurethane, die sich von Polyethern, Polyestern und Polybutadienen mit endständigen Hydroxylgruppen einerseits und aliphatischen oder aromatischen Polyisocyanaten andererseits ableiten, sowie deren Vorprodukte.

Bevorzugt handelt es sich bei den thermoplastischen Polymeren um Polyamide und Copolyamide, die sich von Diaminen und Dicarbonsäuren und/oder von Aminocarbonsäuren oder den entsprechenden Lactamen ableiten, wie Polyamid 2/12, Polyamid 4 (Poly-4-aminobuttersäure, ®Nylon 4, Fa. DuPont), Polyamid 4/6 (Poly(tetramethylen-adipamid), Poly-(tetramethylen-adipinsäurediamid), ®Nylon 4/6, Fa. DuPont), Polyamid 6 (Polycaprolactam, Poly-6-aminohexansäure, ®Nylon 6, Fa. DuPont, ®Akulon K122, Fa. DSM; ®Zytel 7301, Fa. DuPont; ®Durethan B 29, Fa. Bayer), Polyamid 6/6 (Poly-N,N'-hexamethyleneadipinediamid), ®Nylon 6/6 , Fa. DuPont, ®Zytel 101, Fa. DuPont; ®Durethan A30, ®Durethan AKV, ®Durethan AM, Fa. Bayer; ®Ultramid A3, Fa BASF), Polyamid 6/9 (Poly(hexamethylen nonanediamid), ®Nylon 6/9 , Fa. DuPont), Polyamid 6/10 (Poly(hexamethylen sebacamid), ®Nylon 6/10 , Fa. DuPont), Polyamid 6/12 (Poly(hexamethylene dodecanediamid),® Nylon 6/12, Fa. DuPont), Polyamid 6/66 (Poly(hexamethylene adipamide-co-caprolactam), ®Nylon 6/66, Fa. DuPont), Polyamid 7 (Poly-7-aminoheptansäure, ®Nylon 7, Fa. DuPont), Polyamid 7,7 (Polyheptamethylenpimelamid, ®Nylon 7,7, Fa. DuPont), Polyamid 8 (Poly-8-aminooctansäure, ®Nylon 8, Fa. DuPont), Polyamid 8,8 (Polyoctamethylensuberamid, ®Nylon 8,8, Fa. DuPont), Polyamid 9 (Poly-9-aminononansäure, Nylon 9, Fa. DuPont), Polyamid 9,9 (Polynonamethylenazelamid, ^{™}Nylon 9,9, Fa. DuPont), Polyamid 10 (Poly-10-amino-decansäure, ®Nylon 10, Fa. DuPont), Polyamid 10,9 (Poly(decamethylen-azelamid), ®Nylon 10,9, Fa. DuPont), Polyamid 10,10 (Polydecamethylensebacamid, ®Nylon 10,10, Fa. DuPont), Polyamid 11 (Poly-11-aminoundecansäure, ®Nylon 11, Fa. DuPont), Polyamid 12 (Polylauryllactam, ®Nylon 12 , Fa. DuPont, ®Grillamid L20, Fa. Ems Chemie), aromatische Polyamide ausgehend von m-Xylol, Diamin und Adipinsäure; Polyamide, hergestellt aus Hexamethylendiamin und Iso- und/oder Terephthalsäure (Polyhexamethylenisophthalamid, Polyhexamethylenterephthalamid) und gegebenenfalls einem Elastomer als Modifikator, z.B. Poly-2,4,4-trimethylhexamethylenterephthalamid oder Poly-m-phenylenisophthalamid. Blockcopolymere der vorstehend genannten Polyamide mit Polyolefinen, Olefin-Copolymeren, lonomeren oder chemisch gebundenen oder gepfropften Elastomeren; oder mit Polyethern, wie z.B. mit Polyethylenglykol, Polypropylenglykol oder Polytetramethylenglykol. Ferner mit EPDM oder ABS modifizierte Polyamide oder Copolyamide; sowie während der Verarbeitung kondensierte Polyamide ("RIM-Polyamidsysteme").

Bevorzugt handelt es sich bei den thermoplastischen Polymeren um Polyharnstoffe, Polyimide, Polyamidimide, Polyetherimide, Polyesterimide, Polyhydantoine und Polybenzimidazole.

Bevorzugt handelt es sich bei den Polymeren um Polyester, die sich von Dicarbonsäuren und Dialkoholen und/oder von Hydroxycarbonsäuren oder den entsprechenden Lactonen ableiten, wie Polyethylenterephthalat, Polybutylenterephthalat (®Celanex 2500, ®Celanex 2002, Fa Celanese; ®Ultradur, FA. BASF), Poly-1,4-dimethylolcyclo-hexanterephthalat, Polyhydroxybenzoate, sowie Block-Polyether-ester, die sich von Polyethern mit Hydroxylendgruppen ableiten; ferner mit Polycarbonaten oder MBS modifizierte Polyester.

Bevorzugt handelt es sich bei den thermoplastischen Polymeren um Polycarbonate und Polyestercarbonate.

Bevorzugt handelt es sich bei den thermoplastischen Polymeren um Polysulfone, Polyethersulfone und Polyetherketone.

Bevorzugt ist ein Verfahren zur Herstellung von flammgeschützten Polymer-Formkörpern, dadurch gekennzeichnet, dass erfindungsgemäße flammgeschützte Polymer-Formmassen durch Spritzgießen (z.B. Spritzgießmaschine Typ Aarburg Allrounder) und Pressen, Schaumspritzgießen, Gasinnendruck-Spritzgießen, Blasformen, Foliengießen, Kalandern, Laminieren oder Beschichten bei höheren Temperaturen zum flammgeschützten Polymer-Formkörper verarbeitet werden.

Verfahren zur Herstellung von flammgeschützten Polymer-Formkörpern, dadurch gekennzeichnet, dass die erfindungsgemäße flammgeschützte Formmasse bei erfindungsgemäßen Massetemperaturen zu Polymer-Formkörpern verarbeitet wird.

Erfindungsgemäß bevorzugte Massetemperaturen sind
bei Polystyrol 200 bis 250°C,
bei Polypropylen 200 bis 300°C,
bei Polyethylenterephthalat (PET) 250 bis 290°C,
bei Polybutylenterephthalat (PBT) 230 bis 270°C,
bei Polyamid 6 (PA 6) 260 bis 290°C,
bei Polyamid 6.6 (PA 6.6) 260 bis 290°C,
bei Polycarbonat 280 bis 320°C.

Die Erfindung betrifft auch flammgeschützte duroplastische Polymer-Formkörper, -Filme, -Fäden und -Fasern enthaltend die erfindungsgemäßen Mischungen und/oder die erfindungsgemäßen flammgeschützten Polymerformmassen.

Bevorzugt handelt es sich bei dem duroplastischen Polymer in den Polymer-Formkörpern, -Filmen, -Fäden und -Fasern um Block-Copolymere mit einem Polybutadien- oder Polyisopren-Block und einem Block aus Styrol oder alpha-Methylstyrol.

Bevorzugt handelt es sich bei dem duroplastischen Polymer in den Polymer-Formkörpern, -Filmen, -Fäden und -Fasern um Block-Copolymere mit einem ersten Polybutadien-Block und einem zweiten Polyethylen-Block oder Ethylen-Propylen-Block.

Bevorzugt handelt es sich bei dem duroplastischen Polymer in den Polymer-Formkörpern, -Filmen, -Fäden und -Fasern auch um Block-Copolymere mit einem ersten ersten Polyisopren-Block und einem zweiten Polyethylen- oder einem Ethylen-Propylen-Block.

Bevorzugt handelt es sich bei dem duroplastischen Polymer in den Polymer-Formkörpern, -Filmen, -Fäden und -Fasern um ein solches, dass auf epoxidierten pflanzlichen Ölen (epoxidiertes Soyabohnen- /Leinsamenöl), Acrylsäurederivaten (Acrylsäure, Crotonsäure, Isocrotonsäure, Methacrylsäure, Cinnamsäure, Maleinsäure, Fumarsäure, Methylmethacrylsäure) und Hydroxyalkyl-Acrylaten und/oder Hydoxyalkyl-Methacrylaten (Hydroxyethyl-methacrylat, Hydroxypropylmethacrylat, Hydroxybutylmethacrylat, Polyethylen-glycolmethacrylat) basiert.

Ein Verfahren zur Herstellung von duroplastischen Formmassen ist dadurch gekennzeichnet, dass die erfindungsgemäßen Mischungen
a) gemeinsam mit anderen/weiteren Monomeren zu flammgeschützten Polymeren umgesetzt werden, oder
b) für sich zu einem Homopolymerisat polymerisiert und dann mit Polymeren nach dem Stand der Technik durch Extrudieren, Compoundieren etc. geblendet werden, oder
c) mit anderen/weiteren Monomeren zu einem Copolymerisat umgesetzt und dann mit weiteren Monomeren vernetzt werden, oder
d) auf ein vorgegebenes Copolymerisat gepfropft werden.

Die Anbindung erfolgt bevorzugt durch die Umsetzung der olefinischen Gruppe der jeweiligen Verbindung in den erfindungsgemäßen Mischungen. Erfindungsgemäß ist auch die Phosphinsäuregruppe bzw. Carboxylsäuregruppen der jeweiligen Verbindung mit geeigneten funktionellen Gruppen der Polymermatrix zu kondensieren. Bevorzugte funktionelle Gruppen sind Hydroxylgruppen.

Die Erfindung betrifft auch flammgeschützte duroplastische Polymerformmassen, enthaltend die erfindungsgemäßen Mischungen.

Bevorzugt handelt es sich bei den duroplastischen Polymeren um ungesättigte Polyesterharze (UP-Harze), die sich von Copolyestern gesättigter und ungesättigter, mehrwertiger insbesondere Dicarbonsäuren oder deren Anhydride mit mehrwertigen Alkoholen, sowie Vinylverbindungen als Vernetzungsmittel ableiten.

UP-Harze werden gehärtet durch radikalische Polymerisation mit Initiatoren (z.B. Peroxiden) und Beschleunigern.

Ungesättigte Polyester können die Estergruppe als Verbindungsglied in der Polymerkette enthalten.

Bevorzugte ungesättigte Dicarbonsäuren und -derivate zur Herstellung der Polyester sind Maleinsäure, Maleinsäureanhydrid und Fumarsäure, Itaconsäure, Citraconsäure, Mesaconsäure.

Diese können abgemischt sein mit bis zu 200 Mol-%, bezogen auf die ungesättigten Säurekomponenten, mindestens einer aliphatischen gesättigten oder cycloaliphatischen Dicarbonsäure.

Bevorzugte gesättigte Dicarbonsäuren sind Phthalsäure, Isophthalsäure, Terephthalsäure, Dihydrophthalsäure, Tetrahydrophthalsäure, Hexahydrophthalsäure, Endomethylentetrahydrophthalsäure, Adipinsäure, Bernsteinsäure, Sebacinsäure, Glutarsäure, Methylglutarsäure, Pimelinsäure.

Bevorzugte mehrwertige, insbesondere zweiwertige, gegebenenfalls ungesättigte Alkohole sind die üblichen acyclische oder cyclische Gruppen aufweisenden Alkandiole und Oxaalkandiole.

Bevorzugte zweiwertige Alkohole sind Ethylenglykol, Propandiol-1,2, Propandiol-1,3, Diethylenglykol, Dipropylenglykol, 2,2-Dimethylpropandiol-1,3, Butandiol-1,3, Butandiol-1,4, Neopentylglykol, Hexandiol-1,6, 2,2-Bis-(4-Hydroxycyclohexyl)-propan, Perhydrobisphenol und andere.

Besonders bevorzugt sind Ethylenglykol, Propandiol-1,2, Diethylenglykol, Triethylenglykol, Polyethylenglykol, und Dipropylenglykol, Cyclohexandiol-1,2, 2,2-Bis-(hydroxy-cyclohexyl)-propan, Trimethylolpropanmonoallylether, Bisphenol A, Bisphenol F, Dialkylmaleat, Bis-oxalkyliertes Bisphenol A, ethoxyliertes oder propoxyliertes Bisphenol A.

Ferner können ein-, drei- oder höherwertige Alkohole mitverwendet werden: Methanol, Ethanol, Butanol, Allylalkohol, Benzylalkohol, Cyclohexanol und Tetrahydrofurfurylal-kohol, Trimethylolpropan, Ethylhexanol, Fettalkohole, Benzylalkohole, 1,2-Di-(allyloxy)-propanol-(3), Glycerin und Pentaerythrit, von Mono-, Di- und Triallylethern und Benzyl-ethern drei- und mehrwertiger Alkohole mit 3-6 C-Atomen z.B. Trimethylolpropandial-lylether, sowie durch Einbau einbasischer Säuren wie Benzoesäure oder Acrylsäure.

Bevorzugte mit ungesättigten Polyestern copolymerisierbare ungesättigte Monomere tragen bevorzugt Vinyl-, Vinyliden- oder Allylgruppen, z.B. bevorzugt Styrol, aber auch beispielsweise kernalkylierte bzw. -alkenylierte Styrole, wobei die Alkylgruppen 1-4 Kohlenstoffatome enthalten können, z.B. Vinyltoluol, Divinylbenzol, alpha-Methylstyrol, tert.-Butylstyrol; Vinylester von Carbonsäuren mit 2-6 Kohlenstoffatomen, bevorzugt Vinylacetat, Vinylpropionat, Vinylbenzoat; Vinylpyridin, Vinylnaphthalin, Vinylcyclohexan, Acrylsäure und Methacrylsäure und/oder ihre Ester (vorzugsweise Vinyl-, Allyl und Methallylester) mit 1-4 Kohlenstoffatomen in der Alkoholkomponente, ihre Amide und Nitrile, Maleinsäureanhydrid, -halb- und -diester mit 1-4 Kohlenstoffatomen in der Alkoholkomponente, -halb- und -diamide oder cyclische Imide wie Butylacrylat, Methylmethacrylat, Acrylnitril, N-Methylmaleinimid oder N-Cyclohexylmaleinimid; Allylverbindungen wie Allylbenzol und Allylester wie Allylacetat, Phthalsäurediallylester, Isophthalsäurediallylester, Fumarsäurediallylester, Allylcarbonate, Diallylphthalate, Diallylcarbonate, Triallylphosphat und Triallylcyanurat.

Bevorzugte Vinylverbindung zur Vernetzung ist Styrol.

Bevorzugte ungesättigte Polyester können die Estergruppe auch in der Seitenkette tragen wie z.B. Polyacrylester und Polymethacrylester.

Bevorzugte Härtersysteme sind Peroxide und Beschleuniger.

Bevorzugte Beschleuniger sind Metallcoinitiatoren und aromatische Amine und/oder UV-Licht und Photosensibilisatoren, z.B. Benzoinether.

Bevorzugte Peroxide sind anorganisch und/oder organische Peroxysäuren, Hydroperoxide, Ozonide, Di-tert.-butylperoxid, tert.-Butylperoctoat, tert.-Butylperpivalat, tert.-Butylper-2-ethylhexanoat, tert.-Butylpermaleinat, tert.-Butylperisobutyrat, Benzoylperoxid, Diacetylperoxid, Succinylperoxid, p-Chlorbenzoylperoxid, Dicyclohexylperoxiddicarbonat, Acetylacetone peroxid, Methylethylketoneperoxide, Cyclohexaneperoxide, Dicumylhydroperoxide, -Butylhydroperoxide, Cumolhydroperoxide, Pinenhydroperoxide, Terpineolozonide.

Bevorzugt werden Initiatoren in Mengen von 0,1 bis 20 Gew.-%, vorzugsweise 0,2 bis 15 Gew.-%, berechnet auf die Masse aller Comonomeren, eingesetzt.

Bevorzugte Metallcoinitiatoren sind Kobalt-, Mangan-, Eisen-, Vanadium -, Nickel- oder Bleiverbindungen, z.B. Kobaltoctanoat, Kobalt-(II)-bis-2-Ethylhexanoat, Kobaltnaphthenat, Vanadiumacetylacetonat.

Bevorzugt werden Metallcoinitiatoren in Mengen von 0,05 bis 1 Gew.-%, berechnet auf die Masse aller Comonomeren, eingesetzt.

Bevorzugte Beschleuniger sind aromatische Amine wie Dimethylanilin, Dimethyl-p-toluol, Diethylanilin, Phenyldiethanolamin, Ethylamin, t-Butylamin, Diethylanilin, Dimethyl-p-toluidin.

Bevorzugte Beschleuniger sind Azokatalysatoren wie Azoisobutyronitril, Mercaptane wie Laurylmercaptan, Bis-(2-ethylhexyl)sulfid und Bis-(2-mercaptoethyl)sulfid.

Ein Verfahren zur Herstellung von flammgeschützten Copolymerisaten ist dadurch gekennzeichnet, dass man (A) mindestens ein ethylenisch ungesättigtes Dicarbonsäureanhydrid, abgeleitet von mindestens einer C₄-C₈-Dicarbonsäure, (B) mindestens eine vinylaromatische Verbindung und (C) mindestens einem Polyol copolymerisiert, (D) mit erfindungsgemäßen Mischungen umsetzt.

Bevorzugt einsetzbar sind Dicyclopentadien-modifizierte ungesättigte Polyester, die durch Reaktion von Dicyclopentadien, Maleinsäureanhydrid, Wasser, gesättigter Alkohol und gegebenenfalls einer weiteren mehrwertige Säure erhalten werden. Der Polyester wird mit einem radikalisch polymerisierbaren Monomer wie Styrol zum Harz vernetzt.

Bevorzugte gesättigte Alkohole sind Ethylenglycol, Diethylenglycol, 1,3-Propandiol, 2-Methyl-1,3-propandiol, 1,4-Butandiol, 1,3-Butandiol, 2,3-Butandiol, Dipropylenglycol, 1,5-Pentandiol, 1,6-Hexanediol, 2,2-Dimethyl-1,3-propandiol, 2-Ethyl-1,4-butandiol, 1,7-Heptandiol, 1,8-Octandiol, 1,9-Nonandiol, 1,10-Decandiol, 1,4-Cyclohexandiol, 1,4-Dimethylolcyclohexan, 2,2-Diethyl-1,3-propandiol, 3-Methyl-1,4-pentandiol, 2,2-Diethyl-1,3-butandiol, 4,5-Nonandiol, Triethylenglycol, Tetraethylenglycol, Glycerin, Trimethylolpropan, Pentaerythritol, Dipentaerythritol etc.

Bevorzugte mehrwertige Säuren sind Maleinsäure, Fumarsäure, Aconitsäure, Itaconsäure, Malonsäure, Bernsteinsäure, Methylbernsteinsäure, 2,2-Dimethylbernsteinsäure, 2,3-Dimethylbernsteinsäure, Hexylbernsteinsäure, Glutarsäure, 2-Methylglutarsäure, 3-Methylglutarsäure, 2,2-Dimethylglutarsäure, 3,3-Dimethylglutarsäure, 3,3-Diethylglutasäure, Adipinsäure, Pimelinsäure, Phthalsäure, Isophthalsäure, Terephthalsäure etc.

Das Molverhältnis von Maleinsäure zu Dicyclopentadien ist bevorzugt größer als 1,5.

Bevorzugt handelt es sich bei den Polymeren um vernetzte Polymere, die sich einerseits von Aldehyden und andererseits von Phenolen, Harnstoff oder Melamin ableiten, wie Phenol-Formaldehyd-, Harnstoff-Formaldehyd- und Melamin-Formaldehydharze.

Bevorzugt handelt es sich bei den Polymeren um trocknende und nicht-trocknende Alkydharze.

Bevorzugt handelt es sich bei den Polymeren um vernetzbare Acrylharze, die sich von substituierten Acrylsäureestern ableiten, wie z.B. von Epoxyacrylaten, Urethanacrylaten oder Polyesteracrylaten.

Bevorzugt handelt es sich bei den Polymeren um Alkydharze, Polyesterharze und Acrylatharze, die mit Melaminharzen, Harnstoffharzen, Isocyanaten, Isocyanuraten, Polyisocyanaten oder Epoxidharzen vernetzt sind.

Bevorzugt handelt es sich bei den Polymeren um vernetzte Epoxidharze, die sich von aliphatischen, cycloaliphatischen, heterocyclischen oder aromatischen Glycidylverbindungen ableiten, z.B. Produkte von Bisphenol-A-diglycidylethern, Bisphenol-F-diglycidylethern, die mittels üblichen Härtern wie z.B. Anhydriden oder Aminen mit oder ohne Beschleunigern vernetzt werden.

Bevorzugt handelt es sich bei den Polymeren um Mischungen (Polyblends) der vorgenannten Polymeren, wie z.B. PP/EPDM, Polyamid/EPDM oder ABS, PVC/EVA, PVC/ABS, PVC/MBS, PC/ABS, PBTP/ABS, PC/ASA, PC/PBT, PVC/CPE, PVC/Acrylate, POM/thermoplastisches PUR, PC/thermoplastisches PUR, POM/Acrylat, POM/MBS, PPO/HIPS, PPO/PA 6.6 und Copolymere, PA/HDPE, PA/PP, PA/PPO, PBT/PC/ABS oder PBT/PET/PC.

Bevorzugte Polyphenylenether sind Homopolymerisate von 2,6-Dimethylphenol (2,6-Dimethyl-1, 4-phenylenether), Styrol-Pfropf-Copolymer von 2,6-Dimethyl-1,4-phenylenether, Copolymer von 6-Dimethylphenol und 2-Methyl-6-phenyl-phenylenether und das Copolymer von 2,6-Dimethylphenol und 2,3,6-Trimethylphenol.

Bevorzugte Schlagzähmodifikatoren für Polyphenylenether sind Comonomere wie Ethylen, Propylen, 1-Buten, 4-Methyl-1-penten, Alkenylaromaten wie Styrol und alpha-Methylstyrol, konjugierte Diene wie Butadien, Isopren und Vinylcarbonsäuren und ihre Derivative wie Vinylacetat, Acrylsäure, Alkylacrylsäure, Ethylacrylat, Methylmethacrylat, Acrylnitril.

Bevorzugte Duroplasten sind Polymere aus der Klasse der Cyanatester, Cyanatester/Bismaleimid-Copolymer, Bismaleimid-Triazin-Epoxy-Blends und Butadien-Polymere, z.B. Butadien-Styrol-Divinylbenzol-Propf-Terpolymer (Ricon RXBK 250 Serie)

Bevorzugte Butadien-Polymere sind Blockcopolymere, die 70-95 Gew.-% ein oder mehrerer Monovinylsubstituierter aromatischer Kohlenwasserstoffverbindung mit 8-18 C-Atomen und 30-5 Gew.-% eines oder mehrerer konjugierter Diene mit 4-12 C-Atomen und wahlweise Vernetzer enthält.

Bevorzugte Monovinylsubstitutierte aromatische Kohlenwasserstoffverbindungen sind Styrol, 3-Methylstyrol, 4-n-Propylstyrol, 4-Cyclohexylstyrol, 4-Dodecylstyrol, 2-Ethyl-4-benzylstyrol, 4-p-Tolylstyrol, 4-(4-Phenyl-N-butyl)styrol, 1-Vinylnaphthalol und 2-Vinylnaphthalol.

Bevorzugte konjugierte Diene sind 1,3-Butadien, Isopren, 2,3-Dimethyl-1,3-butadien, 2,4-Dimethyl-1,3-butadien, 1,3-Octadien, 4,5-Diethyl-1,3-octadien, Ethylbutadien, Piperylen, 3-Butyl-1,3-octadien und Phenyl-1,3-butadien.

Bevorzugte Vernetzungsmittel sind Divinylbenzol, 1,2,4-Trivinylbenzol, 1,3-Divinylnaphthalin, 1,8-Divinylnaphthalin, 1,3,5-Trivinylnaphthalin, 2,4-Divinylbiphenyl, 3,5,4'-Trivinylbiphenyl, 1,2-Divinyl-3,4-Dimethylbenzol, 1,5,6-Trivinyl-3,7-diethylnaphthalin, 1,3-Vinyl-4,5-8-tributylnaphthalin, 2,2'-Divinyl-4-ethyl-4'-propylbiphenyl.

Bevorzugt ist die Anwendung erfindungsgemäßer Mischungen in dielektrischem Kompositmaterial.

Bevorzugtes dielektrisches Kompositmaterial enthält:
40-60 Gew.-% Thermoset Polymer
60-40 Gew.-% anorganischer teilchenförmiger Füllstoff
20-60% Gew.-% Glasverstärkungsmittel
0,1-20 Gew.-% erfindungsgemäße Mischungen.

Besonders bevorzugtes dielektrisches Kompositmaterial enthält:
40-60 Gew.-% Butadien-Styrol-Divinylbenzol-Pfropf-Terpolymer
60-40 Gew.-% anorganischer teilchenförmiger Füllstoff
20-60 Gew.-% Glasverstärkungsmittel
0,1-20 Gew.-% erfindungsgemäße Mischungen.

Bevorzugt ist die Anwendung erfindungsgemäßer Mischungen in einer flammgeschützten Thermoset-Matrix.

Das bevorzugte flammgeschützten Thermoset-Matrix enthält:
25-50 Gew.-% Harzsystem,
10-40 Gew.-% Glasverstärkungsmittel,
5-50 Gew.-% Füllstoff,
0,1-20 Gew.-% erfindungsgemäße Mischungen.

Bevorzugt werden die erfindungsgemäße Mischungen auch in Harzsystemen verwendet, die aus Polybutadien- oder Polyisopren-Harzen oder Mischungen derselben mit ungesättigten Butadien- oder Isopren-enthaltenden Polymeren bestehen, die an einer Vernetzung teilnehmen können.

Bevorzugtes Polybutadien- oder Polyisopren-Harz ist ®B3000 Harz (Fa. Nippon Soda).

Bevorzugte ungesättigte Butadien- oder Isopren-enthaltenden Polymere sind z.B. gepfropfte Blockcopolymere mit Polybutadien- oder Polyisopren-Block mit mindestens 50 Gew.-% 1,2-Addition und einem thermoplastischen Block aus Styrol oder alpha-Methylstyrol, z.B. ^{R}Kraton DX1300 (Shell Chem. Corp).

Bevorzugte ungesättigte Butadien- oder Isopren-enthaltenden Polymere sind z.B. gepfropfte Blockcopolymere mit einem ersten Polybutadien-Block und einem zweiten Polyethylen-Block oder Ethylen-Propylen-Block, z.B. ^{R}Kraton GX1855 (Shell Chem. Corp).

Bevorzugte ungesättigte Butadien- oder Isopren-enthaltenden Polymere sind z.B. gepfropfte Block-Copolymere mit einem ersten Polyisopren-Block und einem zweiten Polyethylen- oder einem Ethylen-Propylen-Block.

Bevorzugt können 1 bis 50 Gew.-% des Gesamtpolymergehaltes an anderen cohärtbaren Copolmeren zugesetzt werden z.B. Copolymere von Butadien oder Isoprene mit Styrol, alpha-Methylstyrol, Acrylat oder Methacrylat, Acrylonitrilmonomeren, Polymere von Ethylen, Ethylen-Propylene-Copolymere und Ethylen-Propylen-Dien-Terpolymrs, Ethylen-Ethylenoxid-Copolymer, Natrukautschuk, Norbornenpolymere wie Polycylopentadien, hydriertes Styrol-Isopren-StyrolCopolymere und Butadien-Acrylonitril-Copolymere.

Bevorzugt einsetzbare Additive zu den erfindungsgemäßen Mischungen sind Co-Flammschutzmittel, Hitzestabilisatoren, Schlagzähmodifikatoren/Prozesshilfsmittel, Gleitmittel, Lichtschutzmittel, Antidrippingmittel, Compatibilizer, Füllstoffe, Verstärkungsstoffe, Keimbildungsmittel, Nukleierungsmittel, Additive zur Lasermarkierung, Hydrolysestabilisatoren, Kettenverlängerer, Farbpigmente, Weichmacher und Plastifizierungsmittel nach dem Stand der Technik.

Das Verfahren zur Herstellung von flammwidrigen duroplastischen Formmassen ist dadurch gekennzeichnet, dass man ein duroplastisches Harz mit den erfindungsgemäße Mischungen oder Flammschutzmittel-Zusammensetzung vermischt und die resultierende Mischung bei Drücken von 3 bis 10 bar und Temperaturen von 20 bis 60°C nass presst (Kaltpressung).

Ein weiteres Verfahren zur Herstellung von flammwidrigen duroplastischen Formmassen ist dadurch gekennzeichnet, dass man ein duroplastisches Harz mit erfindungsgemäßen Mischungen oder Flammschutzmittel-Zusammensetzung vermischt und die resultierende Mischung bei Drücken von 3 bis 10 bar und Temperaturen von 80 bis 150°C nass presst (Warm- oder Heißpressung).

Besonders bevorzugte Duroplaste sind auch solche auf natürlicher Basis, also solche die auf epoxidierten pflanzlichen Ölen (epoxidiertes Soyabohnen-/Leinsamenöl), Acrylsäurederivaten (Acrylsäure, Crotonsäure, Isocrotonsäure, Methacrylsäure, Cinnamsäure, Maleinsäure, Fumarsäure, Methylmethacrylsäure) und Hydroxyalkyl-Acrylaten und/oder Hydoxyalkyl-Methacrylaten (Hydroxyethylmethacrylat, Hydroxypropylmethacrylat, Hydroxybutylmethacrylat, Polyethylenglycolmethacrylat) basieren.

Bevorzugte Verwendungen für flammgeschützte duroplastische Formkörper sind elektrische Schalterteile, Bauteile im Automobilbau, Elektrotechnik, Elektronik, Leiterplatten, Prepregs, Vergussmassen für elektronische Bauteile, im Boots- und Rotorblattbau, in GFK-Außenanwendungen, Haushalts- und Sanitäranwendungen, Engineering-Werkstoffe.

Die Erfindung wird durch die folgenden Beispiele erläutert. Dabei werden folgende Substanzen eingesetzt:
- MBHP: Methacrylsäure-2,3-bishydroxypropylester
- ABHP: Acrylsäure-2,3-bishydroxypropylester
- AMHP: Acrylsäure-2-methyl-2-hydroxymethyl-propylester

In den Beispielen werden die erfindungsgemäßen Mischungen auch als erfindungsgemäßes reaktives Flammschutzmittel bezeichnet.

### Beispiel 1

In einem Fünfhalsrundkolben mit Thermometer, Tropftrichter, KPG-Rührer und Intensivkühler werden 54,4 g MBHB vorgelegt und innerhalb von 0,1 h werden 45,6 g einer 130°C warmen Oxa-Schmelze zudosiert. Mit einem Temperierbad wird die Reaktionslösung auf 50°C temperiert. Es wird ein erfindungsgemäßes reaktives Flammschutzmittel erhalten, dessen analytischen Daten in Tabelle 1 aufgelistet sind. Das reaktive Flammschutzmittel hat eine Hazenzahl von 25.

### Beispiel 1a (Vergleich)

In einem Fünfhalsrundkolben mit Thermometer, Tropftrichter, KPG-Rührer und Intensivkühler werden 54,4 g MBHB und 45,6 g eines Oxa-Pulvers mit einem mittleren Teilchendurchmesser von 3 mm vorgelegt. Mit einem Temperierbad wird die Reaktionslösung auf 60°C temperiert. Es dauert fast 4 h bis der gesamte Feststoff aufgelöst ist. Das reaktive Flammschutzmittel hat eine (unerwünscht hohe) Hazenzahl von 80, was deutlich unerwünschte Nebenreaktionen anzeigt.

### Beispiel 2

Wie in Beispiel 1 werden 52,2 g ABHP vorgelegt und innerhalb von 0,04 h werden 47,8 g einer 130°C warmen Oxa-Schmelze zudosiert. Mit einem Temperierbad wird die Reaktionslösung auf 90°C temperiert. Es wird ein erfindungsgemäßes reaktives Flammschutzmittel erhalten, dessen analytische Daten in Tabelle 1 aufgelistet sind.

### Beispiel 3 (Vergleich)

Nach JP 9124668 wird ein Phosphor enthaltendes ethylenisch ungesättigtes Monomer der Zusammensetzung: 80 Mol-% (entspr. 79 Gew.-%) CH₂=C(CH₃)-CO₂-CH₂CH₂O₂C-CH₂CH₂PO(OH)C₆H₅ und 20 Mol-% (entspr. 21 Gew.-%) CH₂=C(CH₃)-CO₂- CH₂ CH₂O₂C-CH₂CH₂PO(OCH₃)C₆H₅ erhalten.

### Beispiel 4

Wie in Beispiel 1 werden 56,5 g AMHP vorgelegt und innerhalb von 0,3 h werden 43,5 g einer 130°C warmen Oxa-Schmelze zudosiert. Mit einem Temperierbad wird die Reaktionslösung auf 60°C temperiert. Es wird ein erfindungsgemäßes reaktives Flammschutzmittel erhalten, dessen analytische Daten in Tabelle 1 aufgelistet sind.

### Beispiel 5

In einem Fünfhalsrundkolben mit Thermometer, Tropftrichter, KPG-Rührer und Intensivkühler werden 56,8 g MBHP vorgelegt und innerhalb von 0,1 h werden 43,2 g einer 130°C warmen Oxa-Schmelze zudosiert. Mit einem Temperierbad wird die Reaktionslösung auf 50°C temperiert. Es wird eine erfindungsgemäße Flammschutzmittel-Zusammensetzung erhalten, deren analytische Daten in Tabelle 2 aufgelistet sind.

### Beispiel 6

In einem Fünfhalsrundkolben mit Thermometer, Tropftrichter, KPG-Rührer und Intensivkühler werden 78,2 g MBHP vorgelegt und innerhalb von 0,1 h werden 21,8 g einer 130°C warmen Oxa-Schmelze zudosiert. Mit einem Temperierbad wird die Reaktionslösung auf 50°C temperiert. Es wird eine erfindungsgemäße Flammschutzmittel-Zusammensetzung erhalten, deren analytische Daten in Tabelle 2 aufgelistet sind.

### Beispiel 7

Es wurden 13,3 g reaktives Flammschutzmittel von Beispiel 1 vorgelegt und mit weiteren 120 g Methylmethacrylat und 60 mg 2,2' Azodiisobutyronitril (AIBN) versetzt. Dann wird 10 min bei Raumtemperatur gerührt. Die Mischung wird zwischen zwei Glasplatten gegeben und bei 60°C 48 h polymerisiert. Danach werden die Glasplatten 3 h bei 100°C im Trockenschrank zu annähernd 100% Umsatz durchpolymerisiert. Die Glasplatten werden entfernt, die transparente Platte (Dicke 3,2 mm) zu 12,7 mm breiten und 10 cm langen Streifen geschnitten. Diese Probekörper haben den in Tabelle 3 aufgeführten Flammschutzmittel-Gehalt und erzielen den in Tabelle 3 aufgeführten LOI.

### Beispiel 8 (Vergleich)

Wie in Beispiel 7 wurde mit dem reaktives Flammschutzmittel aus Beispiel 3 Probekörper hergestellt und daran der LOI bestimmt. Flammschutzmittel-Gehalt und LOI sind in Tabelle 3 aufgeführt.

### Beispiel 9

Ein ungesättigtes Polyesterharz wurde hergestellt, indem 415 Gew.-Teile Maleinsäureanhydrid, 419 Gew.-Teile Phthalsäureanhydrid, 774 Gew.-Teile Neopentylglycol, 159 Gew.-Teile n-Tetradecanol polykondensiert wurden. Weiterhin wurden 654 Teile des reaktiven Flammschutzmittels aus Beispiel 1 zugegeben. Sechzig Gew.-Teile des Polyesters wurden in 40 Gew.-Teile Vinylversatate-10 gelöst. Zu 25 g des Harzes wurden 0,25ml einer Lösung von Kobaltoctanoat in Dioctylphthalat (1 Gew.-% Co) und 1 ml einer 50 %igen Lösung von Methylethylketoneperoxid in Dimethylphthalat gegeben. Es werden Platten mit 3mm-Schichtdicke gegossen und Prüfkörper zugeschnitten. Der Flammschutzmittel-Gehalt und der erzielte LOI sind in Tabelle 3 aufgeführt.

### Beispiel 10 (Vergleich)

Wie in Beispiel 9 werden Prüfkörper mit dem reaktiven Flammschutzmittel aus Beispiel 3 hergestellt. Der Flammschutzmittel-Gehalt und der erzielte LOI sind in Tabelle 3 aufgeführt.

### Beispiel 11

Es werden 100 Gew.-Teile vorbeschleunigtes Dicyclopentadienylharz (Norpol 507-504), 37 Gew.-Teile reaktives Flammschutzmittel aus Beispiel 1, 2 Gew.-Teile Peroxidhärter (Butanox M 50), 0,5 Gew.-Teile Beschleuniger (Cobalt-(11)-bis(2-ethylhexanoat), NL 49P) homogenisiert, Platten zu 3mm Dicke gegossen und zu Probekörper zugeschnitten. Der Flammschutzmittel-Gehalt und der erzielte LOI sind in Tabelle 3 aufgeführt.

### Beispiel 12 (Vergleich)

Wie in Beispiel 11 werden Prüfkörper mit dem reaktiven Flammschutzmittel aus Beispiel 3 hergestellt. Der Flammschutzmittel-Gehalt und der erzielte LOI sind in Tabelle 3 aufgeführt.

### Beispiel 13

60 Gew.-Teile einer Polyesterharzlösung, die hergestellt wurde aus Maleinsäureanhydrid und Propylenglykol-1,2 im Molverhältnis 1:1 und in Styrol zu einer 65 %igen Lösung gelöst und mit 120 ppm Hydrochinon stabilisiert wurde, sowie 40 Gew.-Teile einer 36 %ige styrolische Lösung von Polymethylmethacrylat die mit 100 ppm Hydrochinon und mit 1200 ppm 2,6 -Dimethylchinon stabilisiert wurde, werden mit 3 Gew.-Teilen Magnesiumhydroxid, 3 Teilen tert.-Butylperbenzoat (50 %ig in Dioctylphthalat), 2 Gew.-Teilen einer Lösung von Kobaltoctanoat in Dioctylphthalat (1 Gew.-% Co), 150 Gew.-Teilen Kreide, 4,5 Gew.-Teilen Zinkstearat und 32,9 Gew.-Teilen reaktivem Flammschutzmittel aus Beispiel 2 eingesetzt.

Mit dieser Harzmischung wurden 96 Teile einer Glasfasermatte aus geschnittenen, etwa 2,6 cm langen Rovings getränkt und zum Eindicken 14 Tage bei 23°C zwischen Polyethylenfolien gelagert. Die eingedickten Formmassen wurden nach Entfernung der Abdeckfolien in einem polierten Stahlwerkzeug 3 min bei 145°C mit einem Druck von 7,45 N/mm² verpresst. Es werden Probekörper zugeschnitten. Der Flammschutzmittel-Gehalt und der erzielte LOI sind in Tabelle 3 aufgeführt.

### Beispiel 14 (Vergleich)

Wie in Beispiel 13 werden Prüfkörper mit dem reaktiven Flammschutzmittel aus Beispiel 3 hergestellt. Der Flammschutzmittel-Gehalt und der erzielte LOI sind in Tabelle 3 aufgeführt.

### Beispiel 15

Es wurde ein Harz hergestellt aus 60 Gew.-Teilen aryliertem Polyphenylenether, 46 Gew.-Teilen Triallylisocyanurat, 25 Gew.-Teilen reaktivem Flammschutzmittel aus Beispiel 1, 15 Gew.-Teilen HU-119 (Silicone, Dow Corning Toray Silicone, Inc.), 4 Gew.-Teilen Beschleuniger, der in Toluol gelöst war (^{R}Par butyl P, Nippon Oil & Fats Co., Ltd.). Aus dem Harz wurde durch Eintauchen von Glasgewebe ein 100µm dickes Prepreg mit 50 % Harzanteil hergestellt. Acht dieser Prepregs wurden aufeinander geschichtet. Auf der Unter- und Oberseite wurde eine 35 µm dicke Kupferfolie hinzugefügt und dieser Stapel 100 min bei 4MPa Druck und 170°C heißgepresst. Es ergab sich ein 1 mm dickes Laminat. Es werden Probekörper zugeschnitten. Der Flammschutzmittel-Gehalt, der erzielte Tg-Wert und die erzielte UL-94-Klassifizierung sind in Tabelle 3 aufgeführt.

### Beispiel 16

Wie in Beispiel 15 werden Prüfkörper mit dem reaktiven Flammschutzmittel aus Beispiel 3 hergestellt. Der Flammschutzmittel-Gehalt, der erzielte Tg-Wert und die erzielte UL-94-Klassifizierung sind in Tabelle 3 aufgeführt.

### Beispiel 17

Es werden 1 kg von Ricon XBK 250 Styrol-Polybutadien-Divinylbenzol-Terpolymer (Ricon Resins, Inc., Grand Junction, CO) in 1kg Toluol gelöst und Verunreinigungen durch ein 300µm Sieb abfiltriert. Dazu wird eine Lösung von 45 g Dicumolperoxid, gelöst in 100 g Toluol zudosiert. 1 kg synthetisches Magnesiumaluminumsilicat (INCOR Corporation,HC-II, 400 µm) und 1150 g reaktives Flammschutzmittel aus Beispiel 1 werden langsam zugemischt. Zusätzlich werden 600 g Toluol zugegeben, um die Homogenisierung der Mischung zu erleichtern. Der Feststoffgehalt der Lösung liegt bei 50-60 %. Die Mischung wird noch einmal durch ein 50µm-Sieb filtriert. Ein E-Glassgewebe wird mit der Lösung beschichtet dass sich folgende Zusammensetzung ergibt: 20 Gew.-% Glasgewebe, 40 % Polymer und 40 % Füller. Das beschichtete Gewebe wird bei 300°C ausgehärtet. Sechs Schichten und eine Kupferfolienschicht wurden zu einem Laminat verpresst. Es werden Probekörper zugeschnitten. Der Flammschutzmittel-Gehalt und die erzielte UL-94-Klassifizierung sind in Tabelle 3 aufgeführt.

### Beispiel 18

Wie in Beispiel 17 werden Prüfkörper mit dem reaktiven Flammschutzmittel aus Beispiel 3 hergestellt. Der Flammschutzmittel-Gehalt und die erzielte UL-94-Klassifizierung sind in Tabelle 3 aufgeführt.

### Beispiel 19

14,6 Gew.-Teile von B3000 Harz (Nippon Soda), 3,8 Gew.-Teile Kraton Rubber (Shell Chemicals), 0,6 Gew.-Teile Luperox 500R (Elf Atochem), 51 Gew.-Teile Aerosil 200 pyrogener Kieselsäure (Degussa), das mit 0,5 Gew-Teilen A176 Silan (OSi) beschichtet wurde, und 7,4 Gew.-Teile reaktivem Flammschutzmittel nach Beispiel 2 werden zu einem Slurry homogen gemischt. Glasgewebe wird mit dem Slurry imprägniert und so ein Prepreg gebildet. 5 Prepregs werden mit ein oder zwei Lagen Kupferfolie bei 165-218°C zu einer Platte verpresst. Es werden Probekörper zugeschnitten. Der Flammschutzmittel-Gehalt und die erzielte UL-94-Klassifizierung sind in Tabelle 3 aufgeführt.

### Beispiel 20

Wie in Beispiel 27 werden Prüfkörper mit dem reaktiven Flammschutzmittel aus Beispiel 3 hergestellt. Der Flammschutzmittel-Gehalt und die erzielte UL-94-Klassifizierung sind in Tabelle 3 aufgeführt.

**Tabelle 1: Flammschutzmittel**

| Beispiel | Einsatzstoffe | | | | Analyse Flammschutzmittel | | | | | |
|---|---|---|---|---|---|---|---|---|---|---|
| | Oxa | Olefin-Komponente (OK) | | OK/ Oxa | P-Gehalt | Gehalt an (I) | Gehalt an (II) | Gehalt an (III) | Gehalt an OK | Chlorid-Gehalt |
| | [g] | Type | [g] | [mol/ mol] | [Gew.-%] | [Gew.-%] | [Gew.-%] | [Gew.-%] | [Gew.-%] | [%] |
| 1 | 45,6 | MBHP | 54,4 | 1 | 10,5 | 98,0 | 2,0 | 0 | 0,0 | 0,0009 |
| 2 | 47,8 | ABHP | 52,2 | 1 | 11,1 | 94,2 | 5,8 | 0 | 0,0 | 0,0007 |
| 3 | - | - | - | - | 9,4 | 0 | 79 | 21 | 0,0 | |
| 4 | 43,5 | AMHP | 56,5 | 1 | 10,1 | 98,9 | 1,1 | 0 | 0,0 | 0,0007 |

**Tabelle 2: Flammschutzmittel-Zusammensetzungen**

| Beispiel | Einsatzstoffe | | | | Analyse Flammschutzmittel-Zusammensetzung | | | | | | |
|---|---|---|---|---|---|---|---|---|---|---|---|
| | Oxa | Olefin-Komponente (OK) | | OK/Oxa | P-Gehalt | Gehalt an (I) | Gehalt an (II) | Gehalt an (III) | Gehalt an OK | Chlorid-Gehalt | Viskosität |
| | [g] | Type | [g] | [mol/ mol] | [Gew.-%] | [Gew.-%] | [Gew.-%] | [Gew.-%] | [Gew.-%] | [%] | [cP] |
| 1 | | | | | | | | | | | 7100 |
| 5 | 43,2 | MBHP | 56,8 | 1,1 | 10,0 | 92,9 | 1,9 | 0 | 5,2 | 0,0009 | 680 |
| 6 | 21,8 | MBHP | 78,2 | 3,0 | 5,0 | 46,9 | 1,0 | 0 | 52,2 | 0,0004 | 250 |

| | | | | | | | | | | | |
|---|---|---|---|---|---|---|---|---|---|---|---|
| I: RO-P(=O)(A)CH2CH2CO2H via 31 P-NMR II: HO-P(=O)(A)CH2CH2CO2R via 31 P-NMR III: H3C-O-P(=O)(A)CH2CH2CO2R | | | | | | | | | | | |

**Tabelle 3: Daten zu flammgeschützten Polymerformkörpern**

| Beispiel | FSM aus Bsp | Gehalt FSM | Gehalt P | LOI | Tg | Verlust faktor | UL-9 Klassifizierung |
|---|---|---|---|---|---|---|---|
| | | [%] | [%] | [% O2] | [°C] | | |
| **7** | **1** | **10,0** | **1,1** | **32** | **-** | **-** | **-** |
| 8 | 3 | 10,0 | 0,9 | 27,0 | - | - | - |
| **9** | **1** | **28,5** | **3** | **31** | **-** | **-** | **-** |
| 10 | 3 | 28,5 | 2,8 | 28 | - | - | - |
| **11** | **1** | **27,0** | **2,8** | **29** | **-** | **-** | **-** |
| 12 | 3 | 27,0 | 2,5 | 25 | - | - | - |
| **13** | **2** | **24,2** | **2,7** | **27** | **-** | **-** | **-** |
| 14 | 3 | 24,2 | 2,3 | 23 | - | - | - |
| **15** | **1** | **16,7** | **1,8** | **-** | **185** | **0,002** | **V-0** |
| 16 | 3 | 18,7 | 1,8 | - | 160 | 0,0035 | V-0 |
| **17** | **1** | **36** | **3,8** | **-** | **-** | **0,0025** | **V-0** |
| 18 | 3 | 38,5 | 3,8 | - | - | 0,004 | V-0 |
| **19** | **2** | **9,4** | **1,0** | **-** | **-** | **0,0025** | **V-0** |
| 20 | 3 | 10,0 | 1,0 | - | - | - 0,0035 | V-0 |

| | | | | | | | |
|---|---|---|---|---|---|---|---|
| Verlustfaktor gemessen bei 1 GHz UL-94 Klassifizierung: nach Vorschrift der Unterwriter Laboratories LOI Limiting Oxygen Index Tg Glasübergangstemperatur FSM: Flammschutzmittel | | | | | | | |

## Patentansprüche

1. Mischungen, enthaltend
(I) 99,9 bis 20 Gew.-% Verbindungen der Formel RO-PO(A)-CH₂-CH₂-CO₂H und
(II) 0,1 bis 80 Gew.-% Verbindungen der Formel HO-PO(A)-CH₂-CH₂-CO₂R
worin
A Methyl, Ethyl, Propyl oder Butyl,
R (D,E)C=C(B, R⁵)
B, D, E gleich oder verschieden sind und jeweils H oder Methyl
R⁵ ein gesättigtes, ungesättigtes oder mehrfach ungesättigtes C₁-C₂₀-(-CO-O-Hydroxyalkylen)
bedeuten, wobei die Summe der Komponenten immer 100 Gew.-% beträgt.

2. Verfahren zur Herstellung von Mischungen, enthaltend Verbindungen der Formel
(I) RO-PO(A)-CH₂-CH₂-CO₂H und
(II) HO-PO(A)-CH₂-CH₂-CO₂R worin
A Methyl, Ethyl, Propyl oder Butyl
R (D,E)C=C(B, R⁵),
B, D, E gleich oder verschieden sind und jeweils H oder Methyl
R⁵ ein gesättigtes, ungesättigtes oder mehrfach ungesättigtes C₁-C₂₀-(-CO-O-Hydroxyalkylen)
bedeuten, **dadurch gekennzeichnet, dass** ein Oxaphospholan der Formel (III) 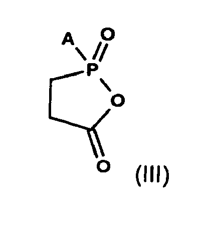 mit einer Di-, Tri- oder Polyhydroxylhaltigen Olefinkomponente umgesetzt wird.

3. Verfahren nach Anspruch 2, **dadurch gekennzeichnet, dass** die Mischungen 99,9 bis 20 Gew.-% an Verbindungen der Formel (I) und 0,1 bis 80 Gew.-% an Verbindungen der Formel (II) enthalten, wobei die Summe der Komponenten immer 100 Gew.-% beträgt.

4. Verwendungen von Mischungen nach Anspruch 1 als Flammschutzmittel oder zur Herstellung von Flammschutzmittel-Zusammensetzungen.

5. Flammschutzmittel-Zusammensetzungen, **dadurch gekennzeichnet, dass** sie 99,9 bis 40 Gew.-% Mischungen nach Anspruch 1 und 0,1 bis 60 Gew.-% Olefinkomponente enthalten, wobei die Summe der Komponenten immer 100 Gew.-% beträgt.

6. Flammgeschützte Polymerformmasse, **dadurch gekennzeichnet, dass** sie
0,5 bis 50 Gew.-% Mischungen nach Anspruch 1,
1 bis 99 Gew.-% thermoplastisches Polymer oder Mischungen derselben,
0 bis 60 Gew.-% Additive und 0 bis 60 Gew.-% Füllstoff enthält, wobei die Summe der Komponenten immer 100 Gew.-% beträgt.

7. Flammgeschützte Polymerformmasse nach Anspruch 6, **dadurch gekennzeichnet, dass** es sich bei den thermoplastischen Polymeren um Polystyrol-HI (High-Impact), Polyphenylenether, Polyamide, Polyester, Polycarbonate und Blends oder Polymerblends vom Typ ABS (Acrylnitril-Butadien-Styrol) oder PC/ABS (Polycarbonat/ Acrylnitril-Butadien-Styrol) handelt.

8. Polymer-Formkörper, -Filme, -Fäden und -Fasern enthaltend 0,5 bis 50 Gew.-% Mischungen nach Anspruch 1 oder eine flammgeschützte Polymerformmasse nach Anspruch 6, wobei es sich bei dem Polymer um ein thermoplastisches oder duroplastisches Polymer handelt.

9. Polymer-Formkörper, -Filme, -Fäden und -Fasern nach Anspruch 8, **dadurch gekennzeichnet, dass** es sich bei dem bei den thermoplastischen Polymeren um Polystyrol-HI (High-Impact), Polyphenylenether, Polyamide, Polyester, Polycarbonate und Blends oder Polymerblends vom Typ ABS (Acrylnitril-Butadien-Styrol) oder PC/ABS (Polycarbonat/ Acrylnitril-Butadien-Styrol), Polyamid, Polyester und/oder ABS handelt.

10. Polymer-Formkörper, -Filme, -Fäden und -Fasern nach Anspruch 8, **dadurch gekennzeichnet, dass** es sich bei den duroplastischen Polymeren um Formaldehyd-, Epoxid-, Melamin- Phenolharz-Polymere und/oder Polyurethane handelt.

11. Polymer-Formkörper, -Filme, -Fäden und -Fasern nach einem oder mehreren der Ansprüche 8 bis 10, **dadurch gekennzeichnet, dass** sie 0,5 bis 50 Gew.-% Mischungen nach Anspruch 1, 1 bis 99 Gew.-% Polymer oder Mischungen derselben, 0 bis 60 Gew.-% Additive und 0 bis 60 Gew.-% Füllstoff enthalten, wobei die Summe der Komponenten immer 100 Gew.-% beträgt.

12. Polymer-Formkörper, -Filme, -Fäden und -Fasern nach Anspruch 11, **dadurch gekennzeichnet, dass** es sich bei dem duroplastischen Polymer um ungesättigte Polyesterharze, Dicyclopentadien-modifizierte ungesättigte Polyester, Polyphenylenether oder Butadien-Polymere handelt.

13. Polymer-Formkörper, -Filme, -Fäden und -Fasern nach einem oder mehreren der Ansprüche 8 bis 12, **dadurch gekennzeichnet, dass** sie in elektrischen Schalterteilen, Bauteilen in Automobilbau, Elektrotechnik, Elektronik, Leiterplatten, Prepregs, Vergussmassen für elektronische Bauteile, im Boots- und Rotorblattbau, in GFK-Außenanwendungen, Haushalts- und Sanitäranwendungen, Engineering-Werkstoffen und weiteren Produkten Anwendung finden.

## Claims

1. A mixture containing
(I) from 99.9 to 20% by weight of compounds of the formula RO-PO(A)-CH₂-CH₂-CO₂H and
(II) from 0.1 to 80% by weight of compounds of the formula HO-PO(A)-CH₂-CH₂-CO₂R
in which
A is methyl, ethyl, propyl or butyl,
R is (D,E)C=C(B, R⁵)
B, D, E are identical or different and are each H or methyl
R⁵ is a saturated, unsaturated or polyunsaturated C₁-C₂₀-(-COO-hydroxyalkylene,
the sum of the components always being 100% by weight

2. A process for the preparation of mixtures containing compounds of the formula
(I) RO-PO(A)-CH₂-CH₂-CO₂H and
(II) HO-PO(A)-CH₂-CH₂-CO₂R
in which
A is methyl, ethyl, propyl or butyl,
R is (D,E)C=C(B, R⁵),
B, D, E are identical or different and are each H or methyl
R⁵ is a saturated, unsaturated or polyunsaturated C₁-C₂₀-(-COO-hydroxyalkylene,
wherein an oxaphospholane of the formula (III) 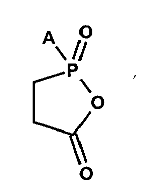 is reacted with an olefin component containing di-, tri- or polyhydroxyl.

3. The process as claimed in claim 2, wherein the mixtures contain from 99.9 to 20% by weight of compounds of the formula (I) and from 0.1 to 80% by weight of compounds of the formula (II), the sum of the components always being 100% by weight.

4. The use of mixtures as claimed in claim 1 as flameproofing agents or for the preparation of flameproofing compositions.

5. A flameproofing composition, which contains from 99.9 to 40% by weight of mixtures as claimed in claim 1 and from 0.1 to 60% by weight of olefin component, the sum of the components always being 100% by weight.

6. A flameproofed polymer molding material, which contains from 0.5 to 50% by weight of mixtures as claimed in claim 1, from 1 to 99% by weight of a thermoplastic polymer or mixtures thereof, from 0 to 60% by weight of additives and from 0 to 60% by weight of a filler, the sum of the components always being 100% by weight.

7. The flameproofed polymer molding material as claimed in claim 6, wherein the thermoplastic polymers are HI (high-impact) polystyrene, polyphenylene ether, polyamides, polyesters, polycarbonates and blends or polymer blends of the ABS (acrylonitrile-butadiene-styrene) or PC/ABS (polycarbonate/acrylonitrile-butadiene-styrene) type.

8. A polymer molding, film, filament or fiber containing from 0.5 to 50% by weight of mixtures as claimed in claim 1 or a flameproofed polymer molding material as claimed in claim 6, the polymer being a thermoplastic or thermosetting polymer.

9. The polymer molding, film, filament or fiber as claimed in claim 8, wherein the thermoplastic polymers are HI (high-impact) polystyrene, polyphenylene ether, polyamides, polyesters, polycarbonates and blends or polymer blends of the ABS (acrylonitrile-butadiene-styrene) or PC/ABS (polycarbonate/acrylonitrile-butadiene-styrene) type, polyamide, polyester and/or ABS.

10. The polymer molding, film, filament or fiber as claimed in claim 8, wherein the thermosetting polymers are formaldehyde-, epoxy- or melamine-phenol resin polymers and/or polyurethanes.

11. The polymer molding, film, filament or fiber as claimed in one or more of claims 8 to 10, which contains from 0.5 to 50% by weight of mixtures as claimed in claim 1, from 1 to 99% by weight of a polymer or mixtures thereof, from 0 to 60% by weight of additives and from 0 to 60% by weight of a filler, the sum of the components always being 100% by weight.

12. The polymer molding, film, filament or fiber as claimed in claim 11, wherein the thermosetting polymer comprises unsaturated polyester resins, dicyclopentadiene-modified unsaturated polyesters, polyphenylene ethers or butadiene polymers.

13. The polymer molding, film, filament or fiber as claimed in one or more of claims 8 to 12, which is used in electrical switch parts, components in automotive construction, electrical engineering, electronics, circuit boards, prepregs, potting compounds for electronic components, in boat and rotor blade construction, in GFR outdoor applications, household and sanitary applications, engineering materials and further products.

## Revendications

1. Mélanges, contenant
(I) 99,9 à 20% en poids de composés de formule RO-PO (A) -CH₂-CH₂-CO₂H et
(II) 0,1 à 80% en poids de composés de formule HO-PO (A) -CH₂-CH₂-CO₂R
où
A signifie méthyle, éthyle, propyle ou butyle,
R signifie (D, E) C=C (B, R⁵)
B, D, E sont identiques ou différents et signifient à chaque fois H ou méthyle
R⁵ signifie C₁-C₂₀- (-CO-O-hydroxyalkylène) saturé, insaturé ou polyinsaturé
la somme des composants valant toujours 100% en poids.

2. Procédé pour la préparation de mélanges, contenant des composés de formule
(I) RO-PO(A)-CH₂-CH₂-CO₂H et
(II) HO-PO(A)-CH₂-CH₂-CO₂R où
A signifie méthyle, éthyle, propyle ou butyle,
R signifie (D,E)C=C(B,R⁵),
B, D, E sont identiques ou différents et signifient à chaque fois H ou méthyle
R⁵ signifie C₁-C₂₀-(-CO-O-hydroxyalkylène) saturé, insaturé ou polyinsaturé
**caractérisé en ce qu'**on transforme un oxaphospholane de formule (III) 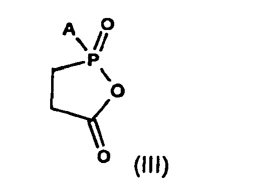
avec un composant oléfinique contenant deux groupes hydroxyle, trois groupes hydroxyle ou plus.

3. Procédé selon la revendication 2, **caractérisé en ce que** les mélanges contiennent 99,9 à 20% en poids de composés de formule (I) et 0,1 à 80% en poids de composés de formule (II), la somme des composants valant toujours 100% en poids.

4. Utilisations de mélanges selon la revendication 1 comme agent ignifuge ou pour la préparation de compositions d'agent ignifuge.

5. Compositions d'agent ignifuge, **caractérisées en ce qu'**elles contiennent 99,9 à 40% en poids de mélanges selon la revendication 1 et 0,1 à 60% en poids de composants oléfiniques, la somme des composants valant toujours 100% en poids.

6. Masse de moulage polymère ignifugée,
**caractérisée en ce qu'**elle contient
- 0,5 à 50% en poids de mélanges selon la revendication 1,
- 1 à 99% en poids de polymère thermoplastique ou de mélanges de ceux-ci,
- 0 à 60% en poids d'additifs et 0 à 60% en poids de charge,
la somme des composants valant toujours 100% en poids.

7. Masse de moulage polymère ignifugée selon la revendication 6, **caractérisée en ce qu'**il s'agit, pour les polymères thermoplastiques, de polystyrène-HI (High-Impact), de polyphénylénéthers, de polyamides, de polyesters, de polycarbonates et de mélanges ou de mélanges polymères de type ABS (acrylonitrile-butadiène-styrène) ou PC/ABS (polycarbonate/acrylonitrile-butadiène-styrène).

8. Corps façonnés, films, fils et fibres polymères contenant 0,5 à 50% en poids de mélanges selon la revendication 1 ou une masse de moulage polymère ignifugée selon la revendication 6, où il s'agit, pour le polymère, d'un polymère thermoplastique ou thermodurcissable.

9. Corps façonnés, films, fils et fibres polymères selon la revendication 8, **caractérisés en ce qu'**il s'agit, pour les polymères thermoplastiques, de polystyrène-HI (High-Impact), de polyphénylénéthers, de polyamides, de polyesters, de polycarbonates et de mélanges ou de mélanges polymères de type ABS (acrylonitrile-butadiène-styrène) ou PC/ABS (polycarbonate/acrylonitrile-butadiène-styrène), polyamide, polyester et/ou ABS.

10. Corps façonnés, films, fils et fibres polymères selon la revendication 8, **caractérisés en ce qu'**il s'agit, pour les polymères thermodurcissables, de polymères de type résine de formaldéhyde, résine époxyde, résine de mélamine, résine phénolique et/ou de polyuréthanes.

11. Corps façonnés, films, fils et fibres polymères selon l'une ou plusieurs des revendications 8 à 10, **caractérisés en ce qu'**ils contiennent
- 0,5 à 50% en poids de mélanges selon la revendication 1,
- 1 à 99% en poids de polymère ou de mélanges de ceux-ci,
- 0 à 60% en poids d'additifs et 0 à 60% en poids de charge,
la somme des composants valant toujours 100% en poids.

12. Corps façonnés, films, fils et fibres polymères selon la revendication 11, **caractérisés en ce qu'**il s'agit, pour le polymère thermodurcissable, de résines de polyester insaturé, de polyesters insaturés modifiés par dicyclopentadiène, de polyphénylénéthers ou de polymères de butadiène.

13. Corps façonnés, films, fils et fibres polymères selon l'une ou plusieurs des revendications 8 à 12, **caractérisés en ce qu'**ils sont utilisés dans les pièces de commutateur électrique, les pièces dans la construction automobile, l'électrotechnique, l'électronique, les circuits imprimés, les préimprégnés, les masses de coulage pour pièces électroniques, dans la construction des bateaux et des pales d'hélice, dans les matériaux synthétiques renforcés par des fibres de verre pour l'extérieur, les utilisations domestiques et sanitaires, les matériaux d'ingénierie et d'autres produits.
